# EUROPEAN PATENT SPECIFICATION

(11) **EP 4 518 090 B1**
(45) Date of publication and mention of the grant of the patent: **02.12.2026**
(21) Application number: 24193873.7
(22) Date of filing: 09.08.2024
(51) Int. Cl.: H02J 7/00

(54) **BATTERY SYSTEM OPERATION**
BATTERIESYSTEMBETRIEB
FONCTIONNEMENT D'UN SYSTÈME DE BATTERIE

(30) Priority: 18.08.2023 US 202363520464 P; 22.05.2024 US 202463650587 P; 28.06.2024 US 202463665573 P; 30.07.2024 US 202418789088
(43) Date of publication of application: 05.03.2025
(73) Proprietor: Analog Devices International Unlimited Company, Limerick (IE)
(72) Inventor: LEVEUGLE, Claire Nelia, Limerick (IE); BERGERON, Joseph S., Wilmington, 01887 (US); O'BRIEN, Michael, Limerick (IE)
(74) Representative: Horler, Philip John

(56) References cited:
- EP-B1- 3 186 651
- WO-A1-2016/106501
- KR-A- 20230 064 580
- US-A1- 2022 163 592
- MEDDINGS NINA ET AL: "Application of electrochemical impedance spectroscopy to commercial Li-ion cells: A review", JOURNAL OF POWER SOURCES, ELSEVIER, AMSTERDAM, NL, vol. 480, 13 September 2020 (2020-09-13), XP086351026, ISSN: 0378-7753, [retrieved on 20200913], DOI: 10.1016/J.JPOWSOUR.2020.228742
- WANG SHANGSHANG ET AL: "Electrochemical impedance spectroscopy", vol. 1, no. 41, 10 June 2021 (2021-06-10), pages 1 - 21, XP093040572, Retrieved from the Internet <URL:https://www.nature.com/articles/s43586-021-00039-w> DOI: 10.1038/s43586-021-00039-w

## Description

### CROSS-REFERENCE TO RELATED APPLICATIONS

This application claims priority to U.S. Nonprovisional Pat. App. No. 18/789,088, filed July 30, 2024, which claims the benefit of: U.S. Provisional Pat. App. No. 63/520,464, filed August 18, 2023; U.S. Provisional Pat. App. No. 63/650,587, filed May 22, 2024; and U.S. Provisional Pat. App. No. 63/665,573, filed June 28, 2024.

### FIELD OF THE DISCLOSURE

This disclosure relates to battery system operation, generally. More specifically, the disclosure describes technology for operating and controlling battery systems through adjusting raw electrochemical impedance spectroscopy data to mitigate the effects of parasitic impedance.

### BACKGROUND

Electrochemical impedance spectroscopy (EIS) may be used to characterize electrochemical systems such as single cells, batteries comprising one or more cells, and battery assemblies (including measurement and control equipment). EIS may measure the complex impedance of one or more cells over a range of frequencies - using the measurements to characterize, *inter alia,* energy state, storage, and dissipation properties of the cell(s), battery, or battery assembly. The data obtained through EIS can be represented in Bode plots or Nyquist plots.

The complex impedance includes a real/resistive component and an imaginary/reactive component. Such complex impedance can be measured as a universal dielectric response,
whereby EIS reveals a power law relationship between the impedance and the frequency *ω* of an applied alternating current (AC) forcing function across a range a frequencies. Such current may be applied using a pair of force wires, and the impedance may be measured using at least one set of sense wires, often one pair of sense wires across each cell. The converse approach to measuring impedance can also be used, i.e., a voltage can be forced and a resulting current can be observed.
EP 3 186 651 B1 discloses a system for electrochemical impedance spectroscopy measurements in battery managements systems in order to determine state of health (SoH) of a rechargeable battery during use, and to balancing of battery cells during use of said battery, i.e. during charging and discharging.
KR 2023 0064580 A discloses an electrochemical impedance spectroscopy (EIS) device that measures the impedance spectrum value of an assembly and a battery charge/discharge measurement device and, based on measurements of the assembly, determines the battery impedance spectrum value in a cell unit.
US 2022/163592 A1 discloses a battery impedance spectra measurement system the receives digital samples of a current through a battery cell and voltage across the battery cell within a measurement period and determines an impedance spectra of the battery cell over the measurement period.

### SUMMARY OF THE DISCLOSURE

In some aspects, the techniques described herein relate to a computer-implemented method of battery operation, the method including: determining, by one or more processors, a reference complex impedance of a reference cell over a range of one or more frequencies; determining, by one or more processors, an in situ complex impedance, over the range of one or more frequencies, of each of one or more cells of a battery with measurement equipment, the battery and the measurement equipment in situ in an end use system, the measurement equipment including one more sense conductors operatively coupled to each one or more cell and one or more force conductors operatively coupled to the battery; for each particular cell of the battery: determining, by one or more processors, a model complex impedance that, when in combination with the complex impedance of the particular cell, accounts at least in part for a difference between the in situ complex impedance of the particular cell and the reference complex impedance; adjusting, by one or more processors, the in situ complex impedance of the particular cell as a function of the model complex impedance; and controlling, by one or more processors, operation of the battery based on the adjusted complex impedance of each of the particular cells.

In some aspects, the techniques described herein relate to a system including: a memory storing instructions therein; and one or more processors communicatively coupled with the memory, the one or more processors being configured to execute the instructions to: determine a reference complex impedance of a reference cell over a range of one or more frequencies; determine an in situ complex impedance, over the range of one or more frequencies, of each of one or more cells of a battery with measurement equipment, the battery and the measurement equipment in situ in an end use system, the measurement equipment including one more sense conductors operatively coupled to each one or more cell and one or more force conductors operatively coupled to the battery; for each particular cell of the battery: determine a model complex impedance that, when in combination with the complex impedance of the particular cell, accounts at least in part for a difference between the in situ complex impedance of the particular cell and the reference complex impedance; adjust the in situ complex impedance of the particular cell as a function of the model complex impedance; and control operation of the battery based on the adjusted complex impedance of each of the particular cells.

In some aspects, the techniques described herein relate to a non-transitory computer-readable medium storing computer executable instructions, the instructions when executed by one or more processors in a network operative to: determine a reference complex impedance of a reference cell over a range of one or more frequencies; determine an in situ complex impedance, over the range of one or more frequencies, of each of one or more cells of a battery with measurement equipment, the battery and the measurement equipment in situ in an end use system, the measurement equipment including one more sense conductors operatively coupled to each one or more cell and one or more force conductors operatively coupled to the battery; for each particular cell of the battery: determine a model complex impedance that, when in series with the complex impedance of the particular cell, accounts at least in part for a difference between the in situ complex impedance of the particular cell and the reference complex impedance; adjust the in situ complex impedance of the particular cell as a function of the model complex impedance; and control operation of the battery based on the adjusted complex impedance of each of the particular cells.

### BRIEF DESCRIPTION OF THE DRAWINGS

The present technology will now be described in more detail with reference to the accompanying drawings, which are not intended to be limiting.
FIG. 1 illustrates a typical set of EIS responses (as Nyquist plots) for a eight standalone cells, in accordance with examples of the technology disclosed herein., in accordance with examples of the technology disclosed herein.
FIG. 2 illustrates a typical set of EIS responses (as Nyquist plots) for a plurality of cells arranged into a battery assembly with EIS force and sense conductor(s) *in situ* in a production unit of an end system, in accordance with examples of the technology disclosed herein.
FIG. 3 illustrates a set of adjusted EIS responses for some cells of FIG. 2, in situ in a production unit of the end system using the battery assembly, in accordance with examples of the technology disclosed herein.
FIG. 4 illustrates a battery assembly including a battery of four cells and EIS measurement equipment, in accordance with examples of the technology disclosed herein.
FIG. 5 illustrates Nyquist plots for the battery assembly of FIG. 4 and two other battery assemblies, in accordance with examples of the technology disclosed herein.
FIG. 6 illustrates three views of currents and magnetic fields (H-field) for the battery assembly of FIG. 4 at 1 kHz, in accordance with examples of the technology disclosed herein.
FIG. 7 is a block diagram of methods of battery operation, in accordance with examples of the technology disclosed herein.
FIG. 8 illustrates raw EIS complex impedance measurements for each of eight cells as those cells are installed as part of a battery assembly with measurement equipment in an end use system, in accordance with examples of the technology disclosed herein.
FIG. 9 illustrates an impedance circuit model for a cell as an element of a battery assembly *in situ* with measurement equipment, in accordance with examples of the technology disclosed herein.
FIG. 10 illustrates an adjusted Nyquist plot for all eight cells of FIG. 8, using the measured complex impedance of one of the cells as the reference complex impedance, in accordance with examples of the technology disclosed herein.
FIG. 11 is a block diagram of methods of battery operation, in accordance with examples of the technology disclosed herein.
FIG. 12 illustrates a plot of the resistance evaluated for an optimal fit versus time constant for each RL tank, in accordance with examples of the technology disclosed herein.
FIG. 13 schematically illustrates a device that may serve as a computer, processor, host, etc., in accordance with examples of the technology disclosed herein.

### DETAILED DESCRIPTION

In the following detailed description, reference is made to the accompanying drawings which form a part hereof wherein like numerals designate like parts throughout, and in which is shown by way of illustration examples that may be practiced. It is to be understood that other examples may be utilized, and structural or logical changes may be made, without departing from the scope of the present disclosure. Therefore, the following detailed description is not to be taken in a limiting sense.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described example. Various additional operations may be performed and/or described operations may be omitted in additional examples.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

Various components may be referred to or illustrated herein in the singular (e.g., a "processor," a "peripheral device," etc.), but this is simply for ease of discussion, and any element referred to in the singular may include multiple such elements in accordance with the teachings herein.

The description uses the phrases "in an example" or "in examples," which may each refer to one or more of the same or different examples. Furthermore, the terms "comprising," "including," "having," and the like, as used with respect to examples of the present disclosure, are synonymous. As used herein, the term "circuitry" may refer to, be part of, or include an application-specific integrated circuit (ASIC), an electronic circuit, and optical circuit, a processor (shared, dedicated, or group), and/or memory (shared, dedicated, or group) that execute one or more software or firmware programs, a combinational logic circuit, and/or other suitable hardware that provide the described functionality.

Electrochemical systems include both galvanic and electrolytic electrochemical systems such as vehicle batteries, fuel cells, electrochemical capacitors, bio-electrochemical systems, electrochemical sensors, corrosion cells, photo chemical cells, thermos-galvanic cells, and electrochromic system, and can be individual cells or batteries of cells. The technology disclosed herein, while illustrated with respect to galvanic batteries of one or more cells, applies to electrochemical systems in general.

EIS can be used as a tool for generating insights into battery operation in systems such as electric vehicles (EVs), energy storage systems, and various consumer systems. As the dimensions of individual cells become larger, their impedance starts to reduce. This impedance reduction can become further compounded as original equipment manufacturers (OEMs) increase the number of cells connected in parallel in a battery. Such impedance reduction, regardless of the reason, may cause other factors, such as parasitic impedance effects from EIS force wires and sense wires, mutual inductance between cells, skin effect, and eddy currents to affect, even dominate, raw EIS measurements. Consider that OEMs are generally restricted with the physical arrangement/form-factors used for battery system (including EIS measurement components) design. This often makes it impractical for an OEM to offer optimal (from an EIS perspective) cable routing in an end use system, such as a vehicle - hence likely increasing the effect of such other factors on EIS measurements. Unless accounted for, such effects may severely impact the performance of EIS-based algorithms.

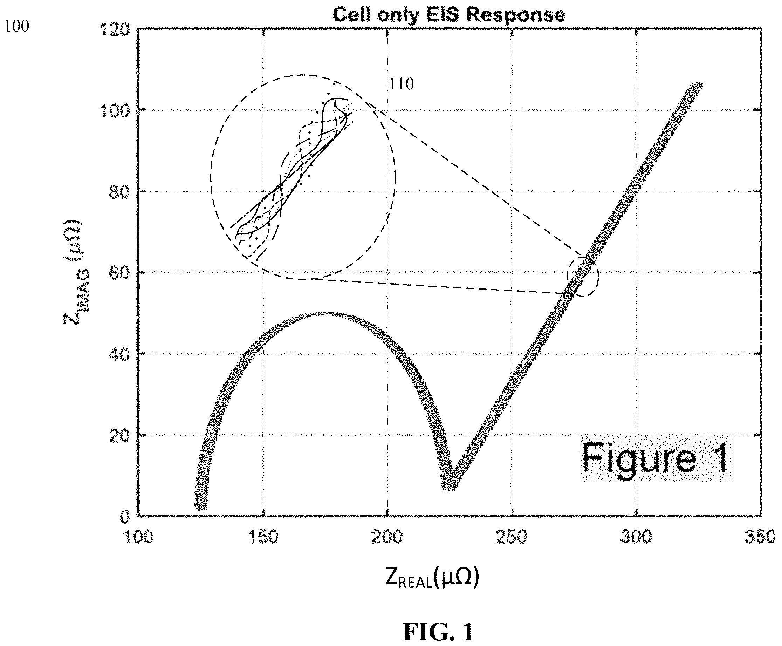

Referring to FIG. 1, a typical set of EIS Nyquist responses 100 for a plurality, eight in this case, of standalone cells (cells tested in isolation from each other, and in low electromagnetic noise environments) is illustrated, in accordance with examples of the technology disclosed herein. The represented cells are each at a similar operating point, e.g., same state-of-charge (SoC), same temperature, and same age. Given that each cell is in a similar state and no other cells are interfering with the measurement (e.g. lab conditions and cable routing are controlled as best as practical), the EIS responses (real and imaginary impedance) of each cell align very closely - within minor expected cell-to-cell variation, e.g., as illustrated in inset 110. In general, data points to the upper right correspond to lower frequencies of the EIS response of the cell, and points proceeding counterclockwise from the upper right correspond to higher frequencies of the EIS response to the cell.

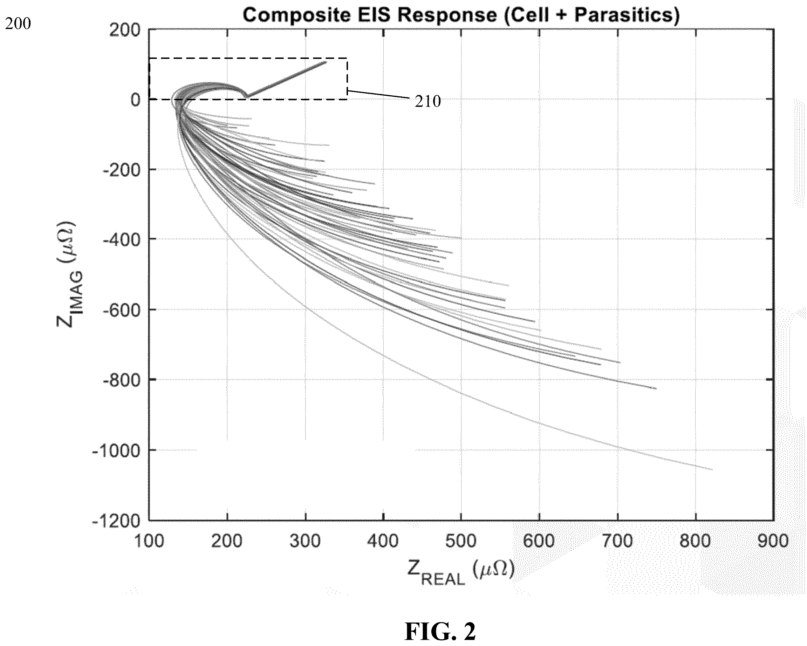

Referring to FIG. 2, a typical set of EIS responses 200 for a plurality of cells with EIS force and sense conductor(s) *in situ* in a production unit of an end system is illustrated, in accordance with examples of the technology disclosed herein. Box 210 approximates the scale of the real and imaginary axes of FIG. 1. Inside box 210, it can be seen that the data for each cell begins to vary from that of FIG. 1 as the frequency of the forcing function increases, and then increasingly varies from each other outside of box 210. It can be difficult to engineer an EIS-based algorithm for battery operation from such noisy/skewed data.

Examples of the technology disclosed herein can account for, and adjust for, the effect of factors such as such as parasitic impedance effects from EIS force wires and sense wires, mutual inductance between cells, skin effect, and eddy currents on raw EIS measurements - either with or without attributing the adjustments to any particular factor. The adjusted EIS measurements can be used to control operation of the battery, e.g., controlling charging periods based on SoC determined using EIS, controlling cell temperature, controlling cell pressure. The adjusted EIS measurements can be reported to other processes that use the information to monitor and control battery and end-use system operation.

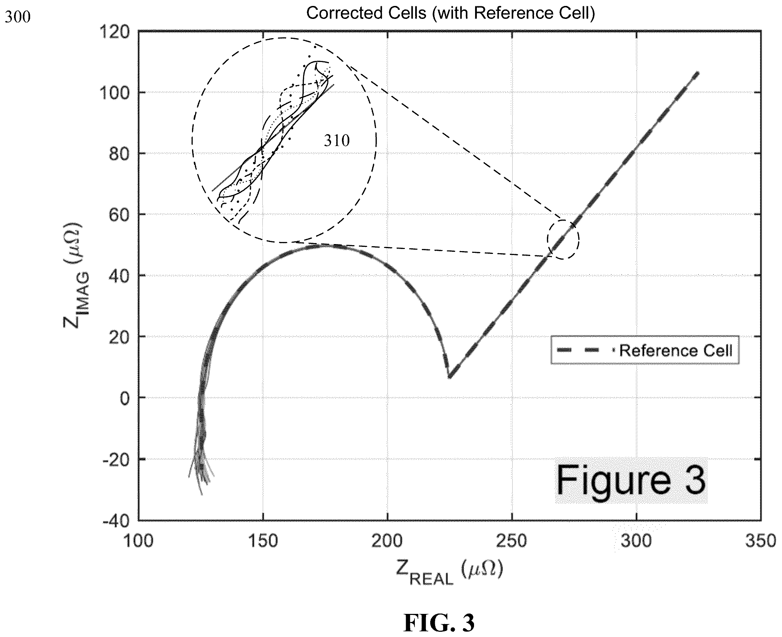

Referring to FIG. 3, and continuing to refer to prior figures for context, a set of adjusted EIS responses 300 for some cells of FIG. 2, *in situ* in a production unit of the end system using the battery assembly is illustrated, in accordance with examples of the technology disclosed herein. In FIG. 3, a reference complex impedance and a model complex impedance were used to adjust the raw EIS values collected as depicted in FIG. 2. Inset 310 illustrates minor remaining variations.

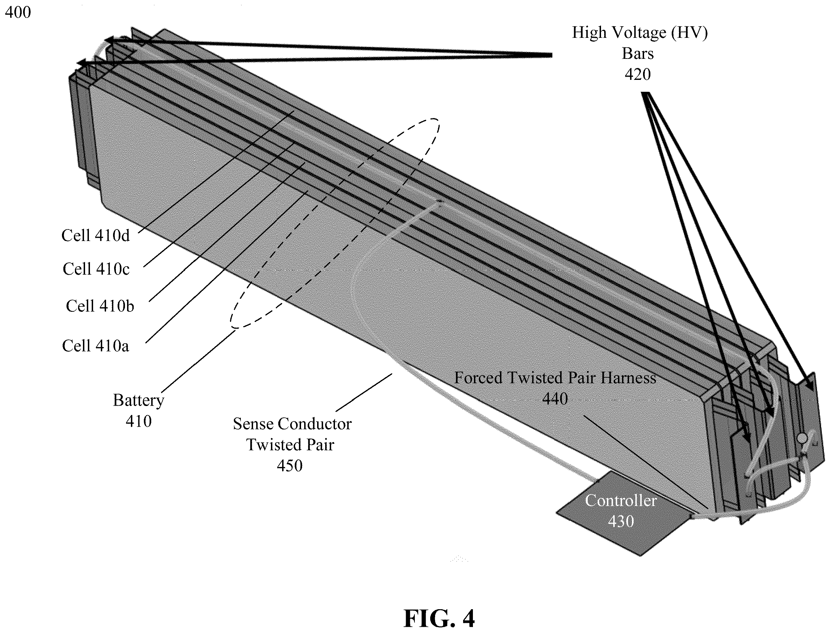

Referring to FIG. 4, and continuing to refer to prior figures for context, a battery assembly 400 including a battery 410 (of four cells 410a - 410d) and EIS measurement equipment 430, 440, 450 is shown, in accordance with examples of the technology disclosed herein. The four cells 410a - 410d are connected in series by high voltage (HV) bars 420 to form the battery 410. The EIS measurement equipment includes a controller 430, force conductors 440, and sense conductors 450. The conductors are shown in this example battery assembly 400 as twisted pairs, but can be single conductors with a ground return in appropriate circumstances.

The controller 430 transmits an AC forcing function over a set of force conductors 440 that are split near the right side HV bars 420 and then connected across the series-connected cells 410a to 410d. While the force conductors 440 in this example are a twisted pair, other conductors can be used. The forcing function can be any signal that contains the EIS frequencies of interest, e.g., a step pulse, a series of step pulses, a swept wave, a square wave, a series of combined individual sinusoids at different frequencies, and a stochastic broadband signal. The controller 430 independently senses the first cell 410a using a set of twisted pair of sense conductors 450 that are split to connect across the first cell 410a - only the sense conductors 450 for the first cell 410a are shown in this example. Note that twisted pair sense conductors 450 cross the first cell 410a and second cell 410b before splitting over the third cell 410c.

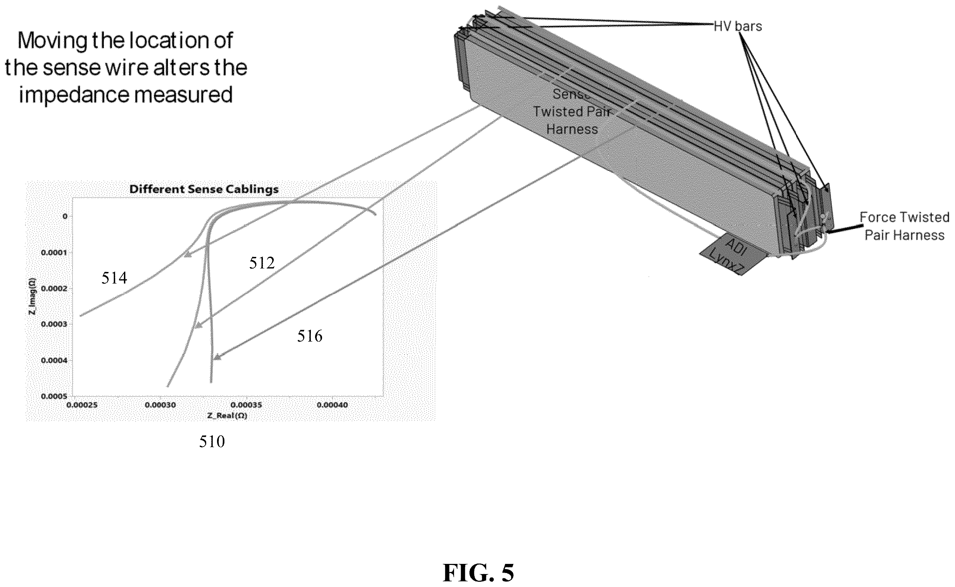

Referring to FIG. 5, and continuing to refer to prior figures for context, Nyquist plots 510 for the sense conductor routing of battery assembly 400 across the third cell 410c (corresponding to Nyquist plot 512), and two other sense conductor 450 routings (same cells, controller, HV bars) are illustrated, in accordance with examples of the technology disclosed herein. In one other routing, the split of sense conductors 450 is routed over the first cell 410a alone. The Nyquist plot 514 corresponding to the routing of sense conductors 450 across cell 410a shows lower real impedance as the frequency of the forcing function increases when compared to the Nyquist plot 512 for the routing of battery assembly 400. In yet another routing, the sense conductors 450 are routed across each of the first cell 410a, the second cell 410b, and the third cell 410c before splitting over the fourth cell 410d. The Nyquist plot 516 corresponding to that routing shows higher real impedance as the frequency of the forcing function increases when compared to the Nyquist plot 512 for battery assembly 400. FIG. 5 illustrates the possible dramatic influence of measurement equipment routing on the raw EIS data.

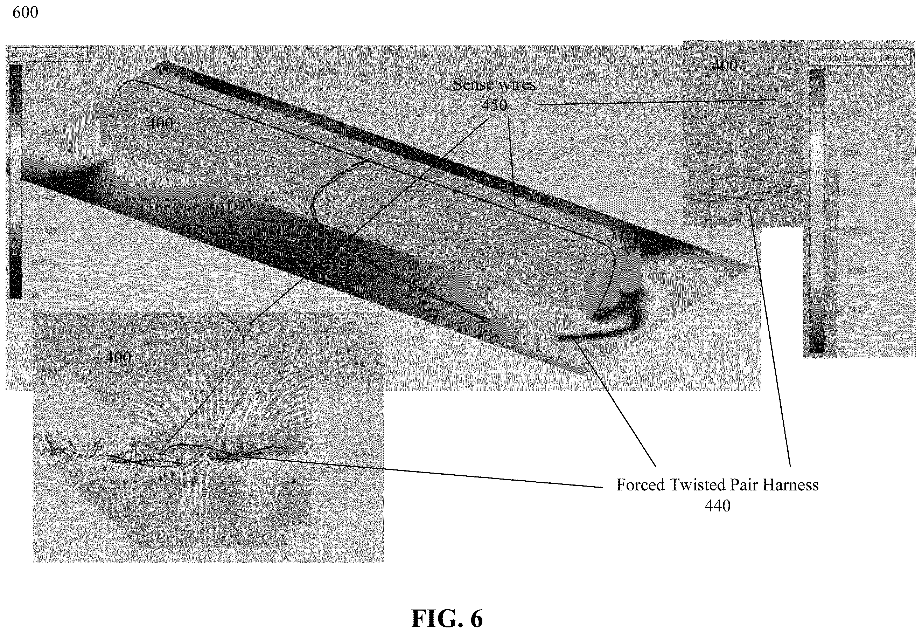

Referring to FIG. 6 and continuing to refer to prior figures for context, three views 600 of currents and magnetic fields (*H*-field) for battery assembly 400 at 1 kHz are illustrated, in accordance with examples of the technology disclosed herein. In the views 600, sense conductors 450 can be seen to be exposed to *H* field of the force conductors 440 and carry currents induced by such *H* fields.

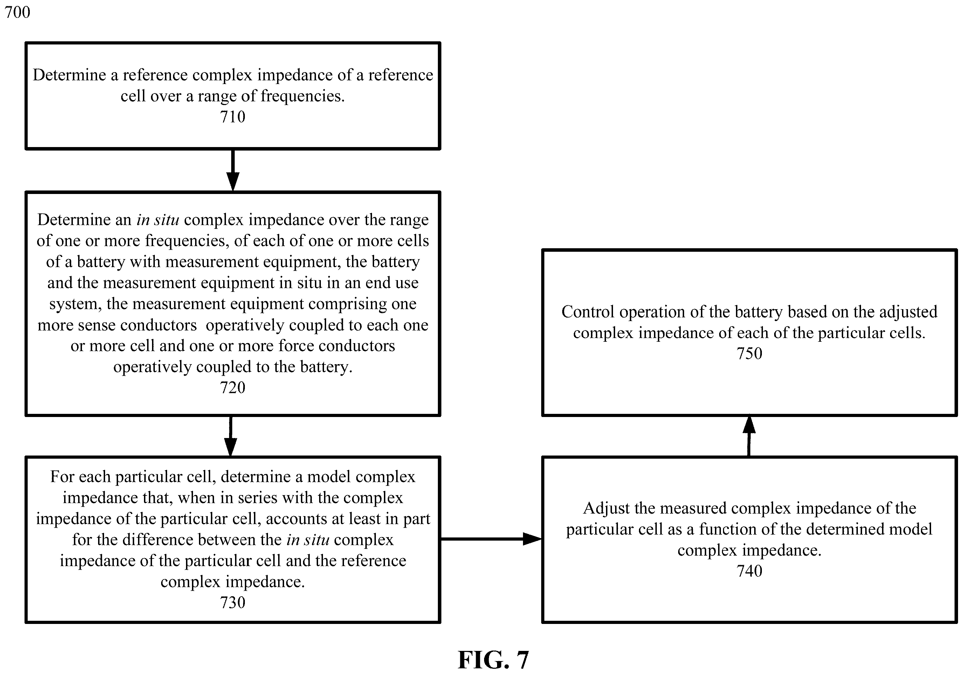

Referring to FIG. 7, and continuing to refer to prior figures for context, methods 700 of battery operation are illustrated, in accordance with examples of the technology disclosed herein.

In such methods 700, a reference complex impedance of a reference cell is determined over a range of one or more frequencies - **Block 710.** In a continuing example using an eight-cell battery, the complex impedance of a reference cell of the same type and similar operating point (e.g., same SoC, same expected operating temperature, same age) as the cells to be used in the battery is measured. In some such examples, the complex impedance of a reference cell is measured in an environment that minimizes the effect of the measurement equipment on the determined impedance.

In some such examples, the complex impedance of a physical reference cell is measured using equipment such as controller 430, force conductors 440, and sense conductors 450 connected to a computer (such as device 1300). In some examples, an impedance of a notional, theoretical, or abstract cell is used as the determined reference cell complex impedance using one or more computers such as device 1300. In some examples, the complex impedance of one or more of the cells of the battery *in situ* with the measurement equipment in an end use system is used as the determined reference cell complex impedance. In some examples, the one or more frequencies included swept frequencies from < 1 Hz to several kHz - though it is the useful range of characterization for the particular observation or control method that determines the frequencies of interest. In some examples, the one or more frequencies include one or more discrete frequencies across the range.

In such methods 700, an *in situ* complex impedance of each of one or more cells of a battery in an end use system with measurement equipment is determined over the range of one or more frequencies - **Block 720.** In the continuing example, the measurement equipment is used to determine the *in situ* complex impedance, and the measurement equipment includes one more sense conductors operatively coupled to each one or more cell and one or more force conductors operatively coupled to the battery, e.g., as in FIG. 4 - FIG. 6.

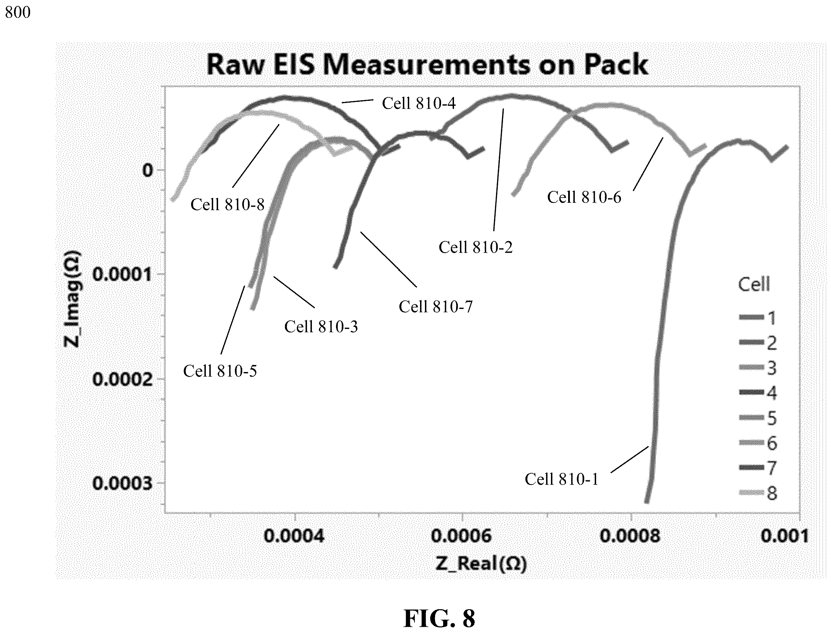

Referring to FIG. 8, and continuing to refer to prior figures for context, raw EIS complex impedance measurements 800 for the continuing example are illustrated for each of cell 810-1 through cell 810-8 as those cells are installed as part of a battery assembly with measurement equipment in an end use system, in accordance with examples of Block 720.

In some methods 700, the measurement equipment includes a controller 430, one or more force conductors 440, and one or more sense conductors 450 per each cell to be measured. In the continuing example, the end use system is a vehicle, and an eight-cell battery and measurement equipment 430, 440, 450 are installed in the vehicle - along with typical vehicle equipment such as a drive train, transmission, cables for power and control, etc. The non-battery assembly components of the vehicle may also contribute to the noise in the raw *in situ* EIS measurements. In some examples, a single force conductor 440 is used from the controller 430 and the return path is through ground. In the continuing example, the one or more force conductors are a twisted pair of wires, as is each of the sense conductors. In some examples, all or some portion of the measurement equipment is also used to perform the determination during operation of the vehicle. In some examples, measurement equipment used to perform the initial determination is different than measurement equipment used to perform the determination during operation of the end system.

In the continuing example, a controller such as controller 430 is connected to a power source and used to apply an AC forcing function with frequency components from 10 Hz - 1kHz across the force conductors 440 connected across the series-connected cells 810-1 through 810-8. The forcing function can sweep across frequencies, or be applied at one or more discrete frequencies. In some examples, the forcing function frequencies are a subset (improper or proper) of the one or more frequencies used to determine the reference complex impedance. The controller 430 then independently senses each cell 410a - 410d using a set of twisted pair of sense conductors 450 that are split to connect across each cell 410a - 410d. In some examples, the battery and measurement equipment 430, 440, 450 are installed in a mock up of vehicle.

In some examples, determination of the *in situ* complex impedance is conducted in software on a computer model of the battery *in situ* in an end use system with measurement equipment. For example, a physical simulation of the battery and measurement equipment can be performed. This can be a 3D EM simulation incorporating the cell shell (or more), force and sense harnesses, and the battery module/pack or the test lab evaluation set-up. The ports are placed at the cell tabs and EIS instrumentation inputs; the simulation output is an s-parameter file that can then be de-embedded from the raw EIS measurements.

In such methods 700, a model complex impedance is determined for each particular cell - **Block 730.** The model complex impedance is such that, when in combination with the actual complex impedance of the particular cell, it accounts at least in part for the difference between the *in situ* complex impedance of the particular cell and the reference complex impedance.

In the some examples, the model complex impedance includes at least one *R*∥*L* tank in series with the complex impedance of the cell, each *R*∥*L* tank including an inductance *L* and a resistance *R* in parallel. In some examples, the model complex impedance is determined by an edge processor platform such as controller 430; in some examples by a computer or platform such as platform 1300 described below; and in some examples by a combination of such platforms. In a minority of examples, *R* = infinity and the model complex impedance is a series *L*.

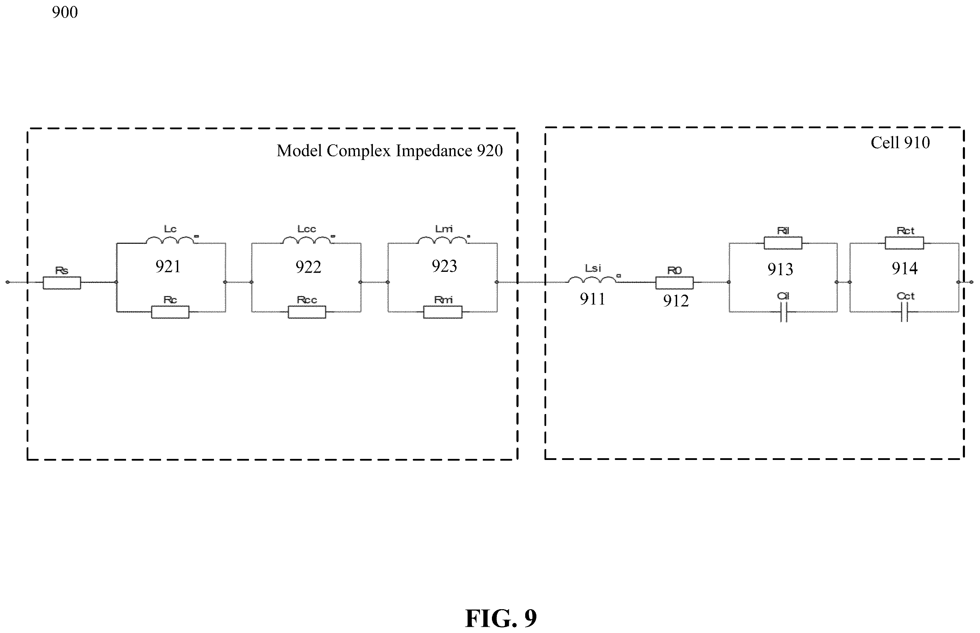

Referring to FIG. 9, and continuing to refer to prior figures for context, an impedance circuit model 900 for a cell 910 as an element of a battery assembly *in situ* with measurement equipment (such as controller 430, force conductors 440, and sense conductors 450) is shown, in accordance with examples of the technology disclosed herein. In the impedance circuit model 900, elements associated with the cell 910 include cell self inductance *Lₛᵢ* 911, cell ohmic behavior *R_{O}* 912, a first *Rᵢₗ*∥*Cᵢₗ* tank 913 (e.g., modeling the behavior of the cell solid electrolyte interface), and a second *R_{ct}*∥*C_{ct}* tank 914 (e.g., modeling the behavior of the charge transfer region of the cell).

In the continuing example, the model complex impedance 920 as shown in impedance circuit model 900 includes three *R*∥*L* tanks (first tank 921, second tank 922, third tank 923) and resistor *Rₛ* in series. Resistor *Rₛ* represents scalar resistance induced by parasitics, e.g., a combination of contact resistance from harness-to-cell tabs and other effects. In this example, the first tank 921, *R_{c}*∥*L_{c}* represents first-order coupling impact from the electromagnetic (EM) field created by force conductor(s) 440 on sense conductor(s) 450. The second tank 922, *R_{cc}*∥*L_{cc}* represents second-order coupling impact from the EM field created by force conductor(s) 440 on sense conductor(s) 450. Note that, depending on the sense and force harnesses/circuitry routing, the model can include additional orders of *L_{c*}* and *R_{c*}.* The third tank 923, *Rₘᵢ*∥*Lₘᵢ* represents mutual inductance from cells other than cell 910 (primarily, from cells adjacent to cell 910). Other *R*∥*L* tanks, in series, can be included to capture other effects external to the cells, for example skin effect (>1MHz frequency), eddy currents, common mode currents, etc. In addition, other schematic representations usefully model the impedances present in the operating environment, including representing third tank 923 *(Rₘᵢ*∥*Lₘᵢ* ) in parallel with the cell 910 impedances.

In the continuing example, the real component of the model complex impedance, which represents the parasitics or the non cell elements, for each cell is given by: ${Z}_{Real _ Modeled} = {R}_{s} + \frac{{ω}^{2} {L}_{mi} {R}_{mi}}{{ω}^{2} {L}_{mi}^{2} + {R}_{mi}^{2}} + \frac{{ω}^{2} {L}_{c} {R}_{c}}{{ω}^{2} {L}_{c}^{2} + {R}_{c}^{2}} + \frac{{ω}^{2} {L}_{cc} {R}_{cc}}{{ω}^{2} {L}_{cc}^{2} + {R}_{cc}^{2}}$ (1)

In the continuing example, the imaginary component of the model complex impedance for each cell is given by: ${Z}_{Imaginary _ Modeled} = ω \left(\frac{{L}_{mi} {R}_{mi}^{2}}{{ω}^{2} {L}_{mi}^{2} + {R}_{mi}^{2}}+\frac{{L}_{c} {R}_{c}^{2}}{{ω}^{2} {L}_{c}^{2} + {R}_{c}^{2}}+\frac{{L}_{cc} {R}_{cc}^{2}}{{ω}^{2} {L}_{cc}^{2} + {R}_{cc}^{2}}\right)$ (2)

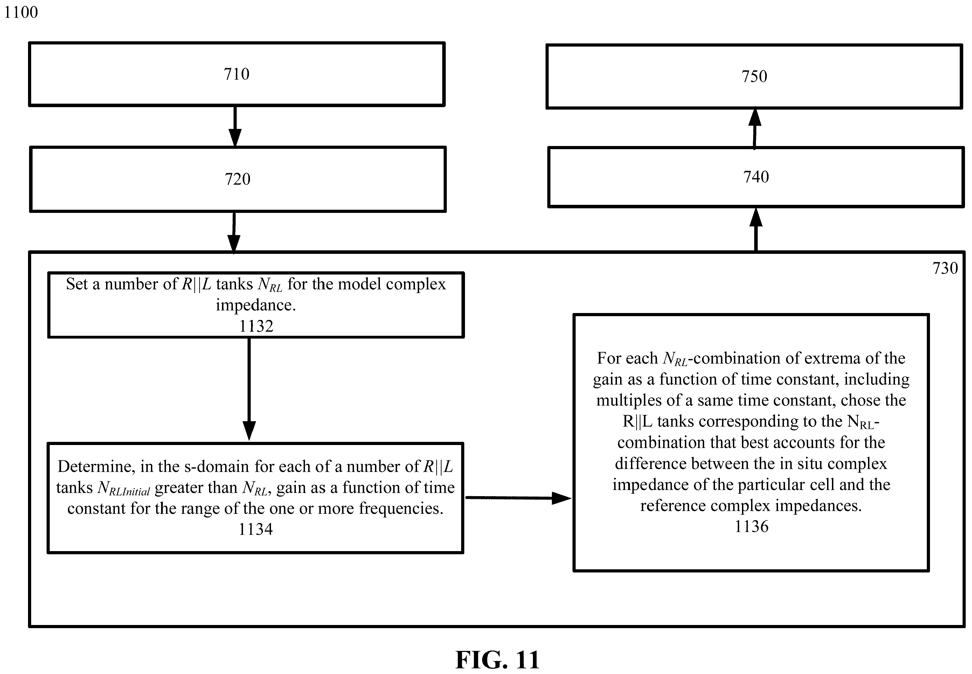

In some examples, the model impedance is determined in accordance with equation (1) and equation (2) as describe below in the discussion of FIG. 11.

In some examples, after selecting a number of *R*∥*L* tanks, *N_{RL},* for the model impedance (e.g., by input to a computer program product), one or more processors executing a computer program product for the purpose, determine gain as a function of time constant for the range of the one or more frequencies in the s-domain for each of a number of *R*∥*L* tanks *N_{RLInitial}* greater than *N_{RL}.* The one or more processors executing the computer program product then derive *R* and *L* values for each of the *N_{RLInitial}* {gain, time constant} pairs. The one or more processors executing the computer program identify the most extrema gains, and further determine the optimum gains at these optimum *N_{RL}* time-constants. Reducing from *N_{RLInitial}* to *~ N_{RL} R*∥*L* tanks, a subset of the time-constants will be selected. Typically, the corresponding gain values for a smaller number of *R*∥*L* tanks will yield a different set of corresponding gain values than the original values. The one or more processors executing the computer program product then identify the model complex impedance as the *N_{RL} R*∥*L* tanks having the derived *R* and *L* values. In some such examples, *N_{RLInitial}* is chosen to be greater than *N_{RL}* by at least one order of magnitude.

In some simple examples, determining the model complex impedance includes using the one or more processors executing instructions of a computer program product to subtract the real and imaginary portions of the reference cell complex impedance from the respective real and imaginary portions of the in situ complex impedance, separately at each of a plurality of frequencies of interest. In some examples, the real component of the complex impedance *Re*(*Z*) and the imaginary component of the complex impedance *Im*(*Z*) are determined for the reference cell a certain number of frequencies. These impedances are subtracted from the corresponding impedances determined for each *in situ* cells at those same frequencies. This gives the model complex impedance for the cell, that when used to adjust future readings will account, at least in part, for parasitics in the future EIS measurements.

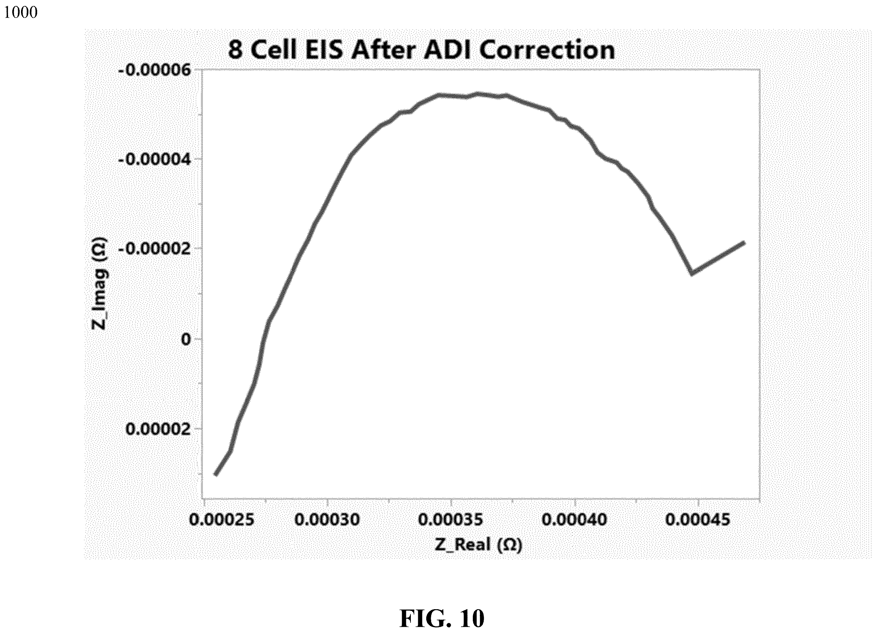

Returning to FIG. 7, in such methods 700, for each particular cell of the battery, the *in situ* complex impedance of the particular cell is adjusted as a function of the model complex impedance - **Block 740.** In the continuing example, the measured *in situ* complex impedance is adjusted by the calculated model complex impedance. Referring to FIG. 10, and continuing to refer to prior figures for context, an adjusted Nyquist plot 1000 for all eight cells of the continuing example, using the measured complex impedance of cell 810-8 as the reference complex impedance is shown, in accordance with examples of the technology disclosed herein. The adjusted complex impedances are nearly identical. In some examples, the adjustment can further include the use of curve fitting techniques, they are many of these functions available in Python, Matlab, Java, etc. - in addition to the direct adjustment using the model complex impedance.

In such methods 700, the operation of the battery is controlled based on the adjusted complex impedance of each of the particular cells - **Block 750.** The adjusted complex impedances of the cell offer information on battery characteristics such as charge transfer, diffusion, state of charge (SoC), state of health (SoH), remaining useful life (RUL), and double layer effects. The adjusted complex impedances mitigate the effect of various noise sources and are used, e.g., by the controller 430, to determine cell and battery characteristics, e.g., charging frequency, charging rate, likelihood of failure, disconnection on over-charge and over-temperature conditions. In the continuing example, SoC data based on the adjusted complex impedances is used to control operation of the battery, e.g., controlling charging periods based on SoC determined using EIS, controlling cell temperature, controlling cell pressure.

Determining values for the model impedance (after determining a reference complex impedance and determining an *in situ* complex impedance for each cell) can be seen as a curve fitting problem, e.g., a cost function can be specified to find the best-fit parameters to align the *in situ* complex impedance with the reference complex impedance - where both impedances are subject to similar operating conditions. In the context of the present technology, the curve fitting problem is non-convex, e.g., there are likely several local solutions in the search space. Consequently, the accuracy of the final fit may depend on initial estimates. This could lead to a sub-optimal fit for the model impedances.

Referring to FIG. 11, and continuing to refer to prior figures for context, methods 1100 for determining values for the model impedance are shown, in accordance with examples of the technology disclosed herein. The methods 1100 are shown in the context of Block 730 of method 700.

In some examples for determining values for the model impedance, a number of *R*|*L* tanks *N_{RL}* to be used in the model complex impedance is set - **Block 1132.** In the continuing example, *N_{RL}* is set to three (3).

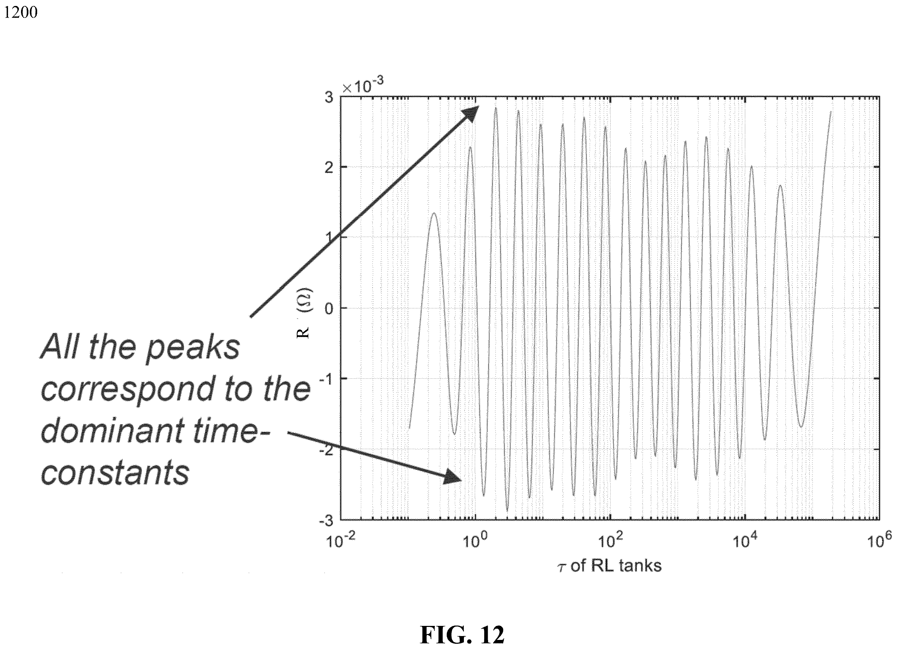

Method 1100 continues by determining, in the s-domain for each of a number of *R*∥*L* tanks *N_{RLInitial}* greater than *N_{RL},* gain as a function of time constant for the range of the one or more frequencies - **Block 1134.** Referring to FIG. 12, and continuing to refer to prior figures for context, a *R*(*Ω*)*=f*(τ) gain plot 1200 for *N_{RLInitial}* equal five hundred (500), is shown in accordance with examples of the technology disclosed herein. The plot shows thirty-two (32) dominant time constants.

By fixing the time constant τ associated with *N_{RLInitial}*, the search problem can be treated as convex, e.g., only a single optimum solution exists. One advantage of such an approach is that determination of the single solution can be computationally more efficient. More computational efficiency allows calculations to be performed in processors closer to the "edge," e.g., controller/processor 430 while the vehicle is in operation. Solving for R in each tank (*L* can also be derived, but it is not needed), the dominant time constants will be discernable. Referring gain to FIG. 12, a τ/ *R(Ω)* plot 1200 for the battery assembly of FIG. 8, using cell 810-8 as the reference cell, is shown. The plot shows thirty-two (32) dominant time constants.

For each *N_{RL}*-combination of extrema of the gain as a function of time constant, including multiples of a same time constant, the *R*∥*L* tanks are chosen corresponding to the *N_{RL}*-combination that best accounts for the difference between the in situ complex impedance of the particular cell and the reference complex impedances - **Block 1136.** In some examples, the fit between the *in situ* complex impedance and the reference complex impedance using the model complex impedance can be refined using off-the-shelf curve fitting techniques.

It is noted that not all parasitic behavior necessarily is captured with a series *R* and *R*∥*L* tanks. In some examples, fixed adjustments could be made, e.g., different filter designs across EIS measurement platforms. In some examples, other physical components could be used as part of the search routine (e.g., capacitors). Physical components can incorporate components with negative values. Non-physical components could be used (e.g., Warburg impedance) in the model complex impedance.

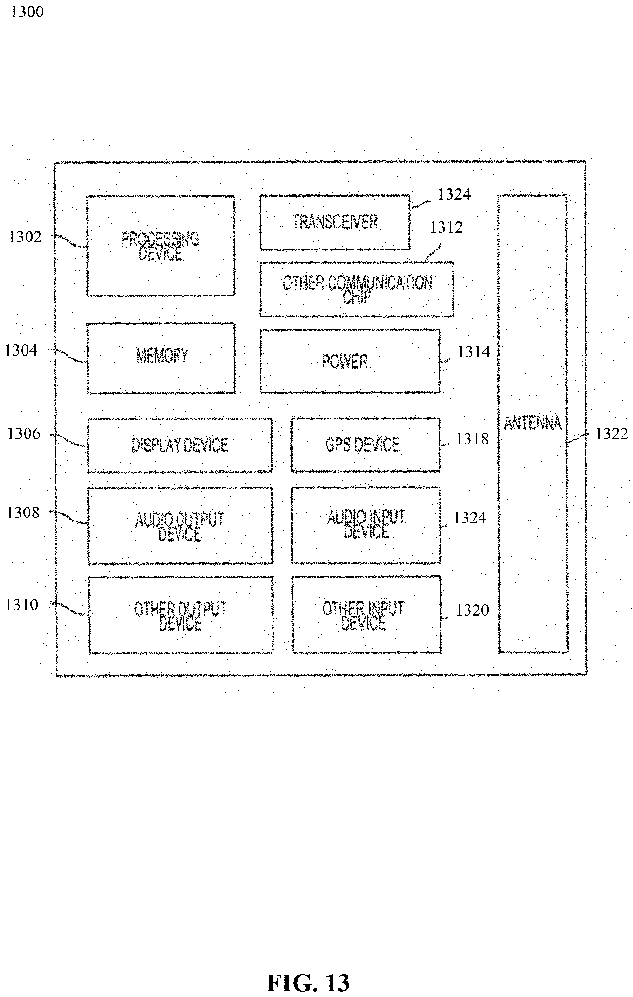

Examples of the present disclosure may be implemented into a system using any suitable hardware and/or software to configure as desired. Referring to FIG. 13, and continuing to refer to prior figures for context, FIG. 13 schematically illustrates a device 1300 that may serve as a computer/processor, in accordance with various examples. A number of components are illustrated in FIG. 13 as included in the device 1300, but any one or more of these components may be omitted or duplicated, as suitable for the application.

Additionally, in various examples, the device 1300 may not include one or more of the components illustrated in FIG. 13, but the device 1300 may include interface circuitry for coupling to the one or more components. For example, the device 1300 may not include a display device 1306, but may include display device interface circuitry (e.g., a connector and driver circuitry) to which a display device 1306 may be coupled. In another set of examples, the device 1300 may not include an audio input device 1324 or an audio output device 1308, but may include audio input or output device interface circuitry (e.g., connectors and supporting circuitry) to which an audio input device 1324 or audio output device 1308 may be coupled.

The device 1300 may include a transceiver 1324, in accordance with any of the examples disclosed herein, for managing communication along the bus when the device 1300 is coupled to the bus. The device 1300 may include a processing device 1302 (e.g., one or more processing devices), which may be included in the node transceiver or separate from the node transceiver. As used herein, the term "processing device" may refer to any device or portion of a device that processes electronic data from registers and/or memory to transform that electronic data into other electronic data that may be stored in registers and/or memory. The processing device 1302 may include one or more DSPs, ASICs, central processing units (CPUs), graphics processing units (GPUs), crypto-processors, or any other suitable processing devices. The device 1300 may include a memory 1304, which may itself include one or more memory devices such as volatile memory (e.g., dynamic random-access memory (DRAM)), non-volatile memory (e.g., read-only memory (ROM)), flash memory, solid state memory, and/or a hard drive.

In some examples, the memory 1304 may be employed to store a working copy and a permanent copy of programming instructions to cause the device 1300 to perform any suitable ones of the techniques disclosed herein. In some examples, machine-accessible media (including non-transitory computer-readable storage media), methods, systems, and devices for performing the above-described techniques are illustrative examples disclosed herein for communication over a two-wire bus. For example, a computer-readable media (e.g., the memory 1304) may have stored thereon instructions that, when executed by one or more of the processing devices included in the processing device 1302, cause the device 1300 to perform any of the techniques disclosed herein.

In some examples, the device 1300 may include another communication chip 1312 (e.g., one or more other communication chips). For example, the communication chip 1312 may be configured for managing wireless communications for the transfer of data to and from the device 1300. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some examples they might not.

The communication chip 1312 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The one or more communication chips 1312 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The one or more communication chips 1312 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The one or more communication chips 1312 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1312 may operate in accordance with other wireless protocols in other examples. The device 1300 may include an antenna 1322 to facilitate wireless communications and/or to receive other wireless communications (such as AM or FM radio transmissions).

In some examples, the communication chip 1312 may manage wired communications using a protocol other than the protocol for the bus described herein. Wired communications may include electrical, optical, or any other suitable communication protocols. Examples of wired communication protocols that may be enabled by the communication chip 1312 include Ethernet, controller area network (CAN), I2C, media-oriented systems transport (MOST), or any other suitable wired communication protocol.

As noted above, the communication chip 1312 may include multiple communication chips. For instance, a first communication chip 1312 may be dedicated to shorter-range wireless communications such as Wi-Fi or Bluetooth, and a second communication chip 1312 may be dedicated to longer-range wireless communications such as global positioning system (GPS), EDGE, GPRS, CDMA, WiMAX, LTE, EV-DO, or others. In some examples, a first communication chip 1312 may be dedicated to wireless communications, and a second communication chip 1312 may be dedicated to wired communications.

The device 1300 may include battery/power circuitry 1314. The battery/power circuitry 1314 may include one or more energy storage devices (e.g., batteries or capacitors) and/or circuitry for coupling components of the device 1300 to an energy source separate from the device 1300 (e.g., AC line power, voltage provided by a car battery, etc.). For example, the battery/power circuitry 1314 may include the upstream bus interface circuitry and the downstream bus interface circuitry discussed above with reference to FIG. 2 and could be charged by the bias on a bus.

The device 1300 may include a display device 1306 (or corresponding interface circuitry, as discussed above). The display device 1306 may include any visual indicators, such as a heads-up display, a computer monitor, a projector, a touchscreen display, a liquid crystal display (LCD), a light-emitting diode display, or a flat panel display, for example.

The device 1300 may include an audio output device 1308 (or corresponding interface circuitry, as discussed above). The audio output device 1308 may include any device that generates an audible indicator, such as speakers, headsets, or earbuds, for example.

The device 1300 may include an audio input device 1324 (or corresponding interface circuitry, as discussed above). The audio input device 1324 may include any device that generates a signal representative of a sound, such as microphones, microphone arrays, or digital instruments (e.g., instruments having a musical instrument digital interface (MIDI) output).

The device 1300 may include a GPS device 1318 (or corresponding interface circuitry, as discussed above). The GPS device 1318 may be in communication with a satellite-based system and may receive a location of the device 1300, as known in the art.

The device 1300 may include another output device 1310 (or corresponding interface circuitry, as discussed above). Examples of the other output device 1310 may include an audio codec, a video codec, a printer, a wired or wireless transmitter for providing information to other devices, or an additional storage device. Additionally, any suitable ones of the peripheral devices may be included in the other output device 1310.

The device 1300 may include another input device 1320 (or corresponding interface circuitry, as discussed above). Examples of the other input device 1320 may include an accelerometer, a gyroscope, an image capture device, a keyboard, a cursor control device such as a mouse, a stylus, a touchpad, a bar code reader, a Quick Response (QR) code reader, or a radio frequency identification (RFID) reader. Additionally, any suitable ones of the sensors or peripheral devices may be included in the other input device 1320.

Any suitable ones of the display, input, output, communication, or memory devices described above with reference to the device 1300 may serve as the peripheral device in system of the technology disclosed herein. Alternatively or additionally, suitable ones of the display, input, output, communication, or memory devices described above with reference to the device 1300 may be included in a host or a node (e.g., a main node or a sub node).

The elements of a system of the technology disclosed herein may be chosen and configured to provide audio and/or light control over the bus. In some examples, the system of the technology disclosed herein may be configured to serve as a light control system in a vehicle or other environment, with lighting devices (e.g., strip-line light-emitting diodes (LEDs) or other LED arrangements) serving as peripheral devices in communication with nodes along the bus; data may be communicated over the bus to control the color, intensity, duty cycle, and/or or other parameters of the lighting devices. In some examples, the system of the technology disclosed herein may be configured to serve as an audio control system in a vehicle or other environment, with a microphone or other device including an accelerometer that may serve as a peripheral device in communication with a node along the bus; data from the accelerometer may be communicated over the bus 106 to control other peripheral devices along the bus. For example, large spikes in the acceleration data or other predetermined acceleration data patterns may be used to trigger the generation of a sound effect, such as a cowbell or drum hit, by a processing device coupled to a node; that sound effect may be output by a speaker coupled to the processing device and/or by a speaker coupled to another node along the bus. Some examples of the system of the technology disclosed herein may combine any of the lighting control and/or audio control techniques disclosed herein.

Although various ones of the examples discussed above describe the system of the technology disclosed herein in a vehicle setting, this is simply illustrative, and the system of the technology disclosed herein may be implemented in any desired setting. For example, in some examples, a "suitcase" implementation of the system of the technology disclosed herein may include a portable housing that includes the desired components of the system of the technology disclosed herein; such an implementation may be particularly suitable for portable applications, such as portable karaoke or entertainment systems.

Having thus described several aspects and examples of the technology of this application, it is to be appreciated that various alterations, modifications, and improvements will readily occur to those of ordinary skill in the art. Such alterations, modifications, and improvements are intended to be within the spirit and scope of the technology described in the application. For example, those of ordinary skill in the art will readily envision a variety of other means and/or structures for performing the function and/or obtaining the results and/or one or more of the advantages described herein, and each of such variations and/or modifications is deemed to be within the scope of the examples described herein.

Those skilled in the art will recognize or be able to ascertain using no more than routine experimentation, many equivalents to the specific examples described herein. It is, therefore, to be understood that the foregoing examples are presented by way of example only and that, within the scope of the appended claims and equivalents thereto, inventive examples may be practiced otherwise than as specifically described. In addition, any combination of two or more features, systems, articles, materials, kits, and/or methods described herein, if such features, systems, articles, materials, kits, and/or methods are not mutually inconsistent, is included within the scope of the present disclosure.

The foregoing outlines features of one or more examples of the subject matter disclosed herein. These examples are provided to enable a person having ordinary skill in the art (PHOSITA) to better understand various aspects of the present disclosure. Certain well-understood terms, as well as underlying technologies and/or standards may be referenced without being described in detail. It is anticipated that the PHOSITA will possess or have access to background knowledge or information in those technologies and standards sufficient to practice the teachings of the present disclosure.

The PHOSITA will appreciate that they may readily use the present disclosure as a basis for designing or modifying other processes, structures, or variations for carrying out the same purposes and/or achieving the same advantages of the examples introduced herein. The PHOSITA will also recognize that such equivalent constructions do not depart from the spirit and scope of the present disclosure, and that they may make various changes, substitutions, and alterations herein without departing from the spirit and scope of the present disclosure.

The above-described examples may be implemented in any of numerous ways. One or more aspects and examples of the present application involving the performance of processes or methods may utilize program instructions executable by a device (e.g., a computer, a processor, or other device) to perform, or control performance of, the processes or methods.

In this respect, various inventive concepts may be embodied as a computer readable storage medium (or multiple computer readable storage media) (e.g., a computer memory, one or more floppy discs, compact discs, optical discs, magnetic tapes, flash memories, circuit configurations in Field Programmable Gate Arrays or other semiconductor devices, or other tangible computer storage medium) encoded with one or more programs that, when executed on one or more computers or other processors, perform methods that implement one or more of the various examples described above.

The computer readable medium or media may be transportable, such that the program or programs stored thereon may be loaded onto one or more different computers or other processors to implement various ones of the aspects described above. In some examples, computer readable media may be non-transitory media.

Note that the activities discussed above with reference to the **FIGURES** which are applicable to any integrated circuit that involves signal processing (for example, gesture signal processing, video signal processing, audio signal processing, analog-to-digital conversion, digital-to-analog conversion), particularly those that can execute specialized software programs or algorithms, some of which may be associated with processing digitized real-time data.

In some cases, the teachings of the present disclosure may be encoded into one or more tangible, non-transitory computer-readable mediums having stored thereon executable instructions that, when executed, instruct a programmable device (such as a processor or DSP) to perform the methods or functions disclosed herein. In cases where the teachings herein are embodied at least partly in a hardware device (such as an ASIC, IP block, or SoC), a non-transitory medium could include a hardware device hardware-programmed with logic to perform the methods or functions disclosed herein. The teachings could also be practiced in the form of Register Transfer Level (RTL) or other hardware description language such as VHDL or Verilog, which can be used to program a fabrication process to produce the hardware elements disclosed.

In example implementations, at least some portions of the processing activities outlined herein may also be implemented in software. In some examples, one or more of these features may be implemented in hardware provided external to the elements of the disclosed figures, or consolidated in any appropriate manner to achieve the intended functionality. The various components may include software (or reciprocating software) that can coordinate in order to achieve the operations as outlined herein. In still other examples, these elements may include any suitable algorithms, hardware, software, components, modules, interfaces, or objects that facilitate the operations thereof.

Any suitably configured processor component can execute any type of instructions associated with the data to achieve the operations detailed herein. Any processor disclosed herein could transform an element or an article (for example, data) from one state or thing to another state or thing. In another example, some activities outlined herein may be implemented with fixed logic or programmable logic (for example, software and/or computer instructions executed by a processor) and the elements identified herein could be some type of a programmable processor, programmable digital logic (for example, an FPGA, an erasable programmable read only memory (EPROM), an electrically erasable programmable read only memory (EEPROM)), an ASIC that includes digital logic, software, code, electronic instructions, flash memory, optical disks, CD-ROMs, DVD ROMs, magnetic or optical cards, other types of machine-readable mediums suitable for storing electronic instructions, or any suitable combination thereof.

In operation, processors may store information in any suitable type of non-transitory storage medium (for example, random access memory (RAM), read only memory (ROM), FPGA, EPROM, electrically erasable programmable ROM (EEPROM), etc.), software, hardware, or in any other suitable component, device, element, or object where appropriate and based on particular needs. Further, the information being tracked, sent, received, or stored in a processor could be provided in any database, register, table, cache, queue, control list, or storage structure, based on particular needs and implementations, all of which could be referenced in any suitable timeframe.

Any of the memory items discussed herein should be construed as being encompassed within the broad term 'memory.' Similarly, any of the potential processing elements, modules, and machines described herein should be construed as being encompassed within the broad term 'microprocessor' or 'processor.' Furthermore, in various examples, the processors, memories, network cards, buses, storage devices, related peripherals, and other hardware elements described herein may be realized by a processor, memory, and other related devices configured by software or firmware to emulate or virtualize the functions of those hardware elements.

Further, it should be appreciated that a computer may be embodied in any of a number of forms, such as a rack-mounted computer, a desktop computer, a laptop computer, or a tablet computer, as non-limiting examples. Additionally, a computer may be embedded in a device not generally regarded as a computer but with suitable processing capabilities, including a personal digital assistant (PDA), a smart phone, a mobile phone, an iPad, or any other suitable portable or fixed electronic device.

Also, a computer may have one or more input and output devices. These devices can be used, among other things, to present a user interface. Examples of output devices that may be used to provide a user interface include printers or display screens for visual presentation of output and speakers or other sound generating devices for audible presentation of output. Examples of input devices that may be used for a user interface include keyboards, and pointing devices, such as mice, touch pads, and digitizing tablets. As another example, a computer may receive input information through speech recognition or in other audible formats.

Such computers may be interconnected by one or more networks in any suitable form, including a local area network or a wide area network, such as an enterprise network, and intelligent network (IN) or the Internet. Such networks may be based on any suitable technology and may operate according to any suitable protocol and may include wireless networks or wired networks.

Computer-executable instructions may be in many forms, such as program modules, executed by one or more computers or other devices. Generally, program modules include routines, programs, objects, components, data structures, etc. that performs particular tasks or implement particular abstract data types. Typically, the functionality of the program modules may be combined or distributed as desired in various examples.

The terms "program" or "software" are used herein in a generic sense to refer to any type of computer code or set of computer-executable instructions that may be employed to program a computer or other processor to implement various aspects as described above. Additionally, it should be appreciated that according to one aspect, one or more computer programs that when executed perform methods of the present application need not reside on a single computer or processor, but may be distributed in a modular fashion among a number of different computers or processors to implement various aspects of the present application.

Also, data structures may be stored in computer-readable media in any suitable form. For simplicity of illustration, data structures may be shown to have fields that are related through location in the data structure. Such relationships may likewise be achieved by assigning storage for the fields with locations in a computer-readable medium that convey relationship between the fields. However, any suitable mechanism may be used to establish a relationship between information in fields of a data structure, including through the use of pointers, tags or other mechanisms that establish relationship between data elements.

When implemented in software, the software code may be executed on any suitable processor or collection of processors, whether provided in a single computer or distributed among multiple computers.

Computer program logic implementing all or part of the functionality described herein is embodied in various forms, including, but in no way limited to, a source code form, a computer executable form, a hardware description form, a computer-implemented method wit memory storing code/instructions therein, and various intermediate forms (for example, mask works, or forms generated by an assembler, compiler, linker, or locator). In an example, source code includes a series of computer program instructions implemented in various programming languages, such as an object code, an assembly language, or a high-level language such as OpenCL, RTL, Verilog, VHDL, Fortran, C, C++, JAVA, or HTML for use with various operating systems or operating environments. The source code may define and use various data structures and communication messages. The source code may be in a computer executable form (e.g., via an interpreter), or the source code may be converted (e.g., via a translator, assembler, or compiler) into a computer executable form.

In some examples, any number of electrical circuits of the FIGURES may be implemented on a board of an associated electronic device. The board can be a general circuit board that can hold various components of the internal electronic system of the electronic device and, further, provide connectors for other peripherals. More specifically, the board can provide the electrical connections by which the other components of the system can communicate electrically. Any suitable processors (inclusive of digital signal processors, microprocessors, supporting chipsets, etc.), memory elements, etc. can be suitably coupled to the board based on particular configuration needs, processing demands, computer designs, etc.

Other components such as external storage, additional sensors, controllers for audio/video display, and peripheral devices may be attached to the board as plug-in cards, via cables, or integrated into the board itself. In another example, the electrical circuits of the FIGURES may be implemented as standalone modules (e.g., a device with associated components and circuitry configured to perform a specific application or function) or implemented as plug-in modules into application-specific hardware of electronic devices.

Note that with the numerous examples provided herein, interaction may be described in terms of two, three, four, or more electrical components. However, this has been done for purposes of clarity and example only. It should be appreciated that the system can be consolidated in any suitable manner. Along similar design alternatives, any of the illustrated components, modules, and elements of the FIGURES may be combined in various possible configurations, all of which are clearly within the broad scope of this disclosure.

In certain cases, it may be easier to describe one or more of the functionalities of a given set of flows by only referencing a limited number of electrical elements. It should be appreciated that the electrical circuits of the FIGURES and its teachings are readily scalable and can accommodate a large number of components, as well as more complicated/sophisticated arrangements and configurations. Accordingly, the examples provided should not limit the scope or inhibit the broad teachings of the electrical circuits as potentially applied to a myriad of other architectures.

Also, as described, some aspects may be embodied as one or more methods. The acts performed as part of the method may be ordered in any suitable way. Accordingly, examples may be constructed in which acts are performed in an order different than illustrated, which may include performing some acts simultaneously, even though shown as sequential acts in illustrative examples.

### Additional Examples

In Example #1, the techniques described herein relate to a computer-implemented method of battery operation, the method including: determining, by one or more processors, a reference complex impedance of a reference cell over a range of one or more frequencies; determining, by one or more processors, an in situ complex impedance, over the range of one or more frequencies, of each of one or more cells of a battery with measurement equipment, the battery and the measurement equipment in situ in an end use system, the measurement equipment including one more sense conductors operatively coupled to each one or more cell and one or more force conductors operatively coupled to the battery; for each particular cell of the battery: determining, by one or more processors, a model complex impedance that, when in combination with the complex impedance of the particular cell, accounts at least in part for a difference between the in situ complex impedance of the particular cell and the reference complex impedance; adjusting, by one or more processors, the in situ complex impedance of the particular cell as a function of the model complex impedance; and controlling, by one or more processors, operation of the battery based on the adjusted complex impedance of each of the particular cells.

In Example #2, in addition to Example #1, the techniques described herein relate to a method, wherein the model complex impedance includes at least one R∥L tank, the R∥L tank including an inductance L and resistance R in parallel. In Example #3, in addition to and one of Example #1 - Example #2, the techniques described herein relate to a method, wherein each R∥L tank in the model complex impedance is in series. In Example #4, in addition to and one of Example #1 - Example #3, the techniques described herein relate to a method, wherein each R∥L tank represents at least one of: coupling from electromagnetic fields created by the one or more force conductors on one or more sense conductors; mutual inductance between cells of the battery and measurement equipment; impedance introduced by contacts of the battery and measurement equipment; skin effect; and eddy currents. In Example #5, in addition to and one of Example #1 - Example #4, the techniques described herein relate to a method, wherein determining the reference complex impedance includes determining the reference complex impedance in an environment that minimizes an effect of the measurement equipment on the determined impedance. In Example #6, in addition to and one of Example #1 - Example #5, the techniques described herein relate to a method, wherein the reference cell is a cell of the battery in situ with measurement equipment in the end use system. In Example #7, in addition to and one of Example #1 - Example #6, the techniques described herein relate to a method, wherein the reference cell is a cell of similar characteristics to each cell of the battery. In Example #8, in addition to and one of Example #1 - Example #7, the techniques described herein relate to a method, wherein controlling operation of the battery includes at least one of: charging, under control of one or more processors, the battery based on the adjusted complex impedance of each of the particular cells; indicating, under control of one or more processors, replacement of one or more cells of the battery based on the adjusted complex impedance of each of the particular cells; and providing, under control of one or more processors, environmental control to one or more cells of the battery based on the adjusted complex impedance of each of the particular cells. In Example #9, in addition to and one of Example #1 - Example #8, the techniques described herein relate to a method, wherein determining the model complex impedance includes: setting, by one or more processors, a number of R∥L tanks NRL for the model complex impedance; determining, by one or more processors, in the s-domain for each of a number of R∥L tanks NRLInitial greater than NRL, gain as a function of time constant for the range of the one or more frequencies; deriving, by one or more processors, R and L values for each of the NRL {gain, time constant} pairs of the most extrema gains; and identifying the model complex impedance as the NRL R∥L tanks having the derived R and L values. In Example #10, in addition to and one of Example #1 - Example #9, the techniques described herein relate to a method, wherein determining the model complex impedance includes: setting, by one or more processors, a number of R∥L tanks NRL for the model complex impedance; determining, by one or more processors, in the s-domain for each of a number of R∥L tanks NRLInitial greater than NRL, gain as a function of time constant for the range of the one or more frequencies; and for each NRL-combination of extrema of the gain as a function of time constant, including multiples of a same time constant, choosing, by one or more processors, the R∥L tanks corresponding to the NRL-combination that best accounts for the difference between the in situ complex impedance of the particular cell and the reference complex impedance. In Example #11, in addition to and one of Example #1 - Example #10, the techniques described herein relate to a method, wherein determining the model complex impedance includes: at each of a plurality of frequencies of interest, subtract the real and imaginary portions of the reference cell complex impedance from the respective real and imaginary portions of the in situ complex impedance.

In Example #12, the techniques described herein relate to a system including: a memory storing instructions therein; and one or more processors communicatively coupled with the memory, the one or more processors being configured to execute the instructions to: determine a reference complex impedance of a reference cell over a range of one or more frequencies; determine an in situ complex impedance, over the range of one or more frequencies, of each of one or more cells of a battery with measurement equipment, the battery and the measurement equipment in situ in an end use system, the measurement equipment including one more sense conductors operatively coupled to each one or more cell and one or more force conductors operatively coupled to the battery; for each particular cell of the battery: determine a model complex impedance that, when in combination with the complex impedance of the particular cell, accounts at least in part for a difference between the in situ complex impedance of the particular cell and the reference complex impedance; adjust the in situ complex impedance of the particular cell as a function of the model complex impedance; and control operation of the battery based on the adjusted complex impedance of each of the particular cells. In Example #13, in addition to Example #12, the techniques described herein relate to a system, wherein controlling operation of the battery includes at least one of: charging, under control of one or more processors, the battery based on the adjusted complex impedance of each of the particular cells; indicating, under control of one or more processors, replacement of one or more cells of the battery based on the adjusted complex impedance of each of the particular cells; and providing, under control of one or more processors, environmental control to one or more cells of the battery based on the adjusted complex impedance of each of the particular cells.

In Example #14, in addition to any one of Example #12 - Example #13, the techniques described herein relate to a system, wherein determining the model complex impedance includes: setting, by one or more processors, a number of R∥L tanks NRL for the model complex impedance; determining, by one or more processors, in the s-domain for each of a number of R∥L tanks NRLInitial greater than NRL, gain as a function of time constant for the range of the one or more frequencies; deriving, by one or more processors, R and L values for each of the NRL {gain, time constant} pairs of the most extrema gains; and identifying the model complex impedance as the NRL R∥L tanks having the derived R and L values. In Example #15, in addition to any one of Example #12 - Example #14, the techniques described herein relate to a system, wherein determining the model complex impedance includes: setting, by one or more processors, a number of R∥L tanks NRL for the model complex impedance; determining, by one or more processors, in the s-domain for each of a number of R∥L tanks NRLInitial greater than NRL, gain as a function of time constant for the range of the one or more frequencies; and for each NRL-combination of extrema of the gain as a function of time constant, including multiples of a same time constant, choosing, by one or more processors, the R∥L tanks corresponding to the NRL-combination that best accounts for the difference between the in situ complex impedance of the particular cell and the reference complex impedance. In Example #16, in addition to any one of Example #12 - Example #15, the techniques described herein relate to a system, wherein determining the model complex impedance includes: at each of a plurality of frequencies of interest, subtract the real and imaginary portions of the reference cell complex impedance from the respective real and imaginary portions of the in situ complex impedance.

In Example #17, the techniques described herein relate to a non-transitory computer-readable medium storing computer executable instructions, the instructions when executed by one or more processors in a network operative to: determine a reference complex impedance of a reference cell over a range of one or more frequencies; determine an in situ complex impedance, over the range of one or more frequencies, of each of one or more cells of a battery with measurement equipment, the battery and the measurement equipment in situ in an end use system, the measurement equipment including one more sense conductors operatively coupled to each one or more cell and one or more force conductors operatively coupled to the battery; for each particular cell of the battery: determine a model complex impedance that, when in combination with the complex impedance of the particular cell, accounts at least in part for a difference between the in situ complex impedance of the particular cell and the reference complex impedance; adjust the in situ complex impedance of the particular cell as a function of the model complex impedance; and control operation of the battery based on the adjusted complex impedance of each of the particular cells.

In Example #18, in addition to Example #17, the techniques described herein relate to a non-transitory computer-readable medium, wherein determining the model complex impedance includes: setting, by one or more processors, a number of R∥L tanks NRL for the model complex impedance; determining, by one or more processors, in the s-domain for each of a number of R∥L tanks NRLInitial greater than NRL, gain as a function of time constant for the range of the one or more frequencies; deriving, by one or more processors, R and L values for each of the NRL {gain, time constant} pairs of the most extrema gains; and identifying the model complex impedance as the NRL R∥L tanks having the derived R and L values.

In Example #19, in addition to any one of Example #17 - Example #18, the techniques described herein relate to a non-transitory computer-readable medium, wherein determining the model complex impedance includes: setting, by one or more processors, a number of R∥L tanks NRL for the model complex impedance; determining, by one or more processors, in the s-domain for each of a number of R∥L tanks NRLInitial greater than NRL, gain as a function of time constant for the range of the one or more frequencies; and for each NRL-combination of extrema of the gain as a function of time constant, including multiples of a same time constant, choosing, by one or more processors, the R∥L tanks corresponding to the NRL-combination that best accounts for the difference between the in situ complex impedance of the particular cell and the reference complex impedance.

In Example #20, in addition to any one of Example #17 - Example #19, the techniques described herein relate to a non-transitory computer-readable medium, wherein determining the model complex impedance includes: at martemper of a plurality of frequencies of interest, subtract the real and imaginary portions of the reference cell complex impedance from the respective real and imaginary portions of the in situ complex impedance.

In some examples, the effects of parasitics are disaggregated from the raw EIS (as described in each of the various examples above). The resultant EIS is then used as an observable to estimate a core temperature of the cell. This estimated core temperature is then used as a factor in controlling the charging time, giving a tradeoff between fast charging while keeping the cell's core temperature in a safe zone.

### Interpretation of Terms

All definitions, as defined and used herein, should be understood to control over dictionary definitions, definitions in documents incorporated by reference, and/or ordinary meanings of the defined terms. Unless the context clearly requires otherwise, throughout the description and the claims: "comprise," "comprising," and the like are to be construed in an inclusive sense, as opposed to an exclusive or exhaustive sense; that is to say, in the sense of "including, but not limited to." "Connected," "coupled," or any variant thereof, means any connection or coupling, either direct or indirect, between two or more elements. The coupling or connection between the elements can be physical, logical, or a combination thereof. "Herein," "above," "below," and words of similar import, when used to describe this specification shall refer to this specification as a whole and not to any particular portions of this specification. "Or," in reference to a list of two or more items, covers all of the following interpretations of the word: any of the items in the list, all of the items in the list, and any combination of the items in the list. The singular forms "a," "an" and "the" also include the meaning of any appropriate plural forms.

Words that indicate directions such as "vertical", "transverse", "horizontal", "upward", "downward", "forward", "backward", "inward", "outward", "vertical", "transverse", "left", "right", "front", "back", "top", "bottom", "below", "above", "under", and the like, used in this description and any accompanying claims (where present) depend on the specific orientation of the apparatus described and illustrated. The subject matter described herein may assume various alternative orientations. Accordingly, these directional terms are not strictly defined and should not be interpreted narrowly.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined.

Elements other than those specifically identified by the "and/or" clause may optionally be present, whether related or unrelated to those elements specifically identified. Thus, as a non-limiting example, a reference to "A and/or B", when used in conjunction with open-ended language such as "comprising" may refer, in one example, to A only (optionally including elements other than B); in another example, to B only (optionally including elements other than A); in yet another example, to both A and B (optionally including other elements); etc.

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

Thus, as a non-limiting example, "at least one of A and B" (or, equivalently, "at least one of A or B," or, equivalently "at least one of A and/or B") may refer, in one example, to at least one, optionally including more than one, A, with no B present (and optionally including elements other than B); in another example, to at least one, optionally including more than one, B, with no A present (and optionally including elements other than A); in yet another example, to at least one, optionally including more than one, A, and at least one, optionally including more than one, B (and optionally including other elements); etc.

As used herein, the term "between" is to be inclusive unless indicated otherwise. For example, "between A and B" includes A and B unless indicated otherwise.

Also, the phraseology and terminology used herein is for the purpose of description and should not be regarded as limiting. The use of "including," "comprising," or "having," "containing," "involving," and variations thereof herein, is meant to encompass the items listed thereafter and equivalents thereof as well as additional items.

In the claims, as well as in the specification above, all transitional phrases such as "comprising," "including," "carrying," "having," "containing," "involving," "holding," "composed of," and the like are to be understood to be open-ended, i.e., to mean including but not limited to. Only the transitional phrases "consisting of" and "consisting essentially of" shall be closed or semi-closed transitional phrases, respectively.

In order to assist the United States Patent and Trademark Office (USPTO) and, additionally, any readers of any patent issued on this application in interpreting the claims appended hereto, Applicant wishes to note that the Applicant: (a) does not intend any of the appended claims to invoke 35 U.S.C. § 112(f) as it exists on the date of the filing hereof unless the words "means for" or "steps for" are specifically used in the particular claims; and (b) does not intend, by any statement in the disclosure, to limit this disclosure in any way that is not otherwise reflected in the appended claims.

It should be understood that the detailed description and specific examples, while indicating examples of the systems and methods are intended for purposes of illustration only and are not intended to limit the scope. These and other features, aspects, and advantages of the systems and methods of the present invention can be better understood from the description, appended claims or aspects, and accompanying drawings. It should be understood that the Figures are merely illustrative and are not drawn to scale. It should also be understood that the same reference numerals are used throughout the figures to indicate the same or similar parts.

Other variations to the disclosed examples can be understood and effected by those skilled in the art in practicing the disclosure, from a study of the drawings, the disclosure, and the appended aspects or claims. In the aspects or claims, the word "comprising" does not exclude other elements or steps, and the indefinite article "a" or "an" does not exclude a plurality. The mere fact that certain measures are recited in mutually different dependent aspects or claims does not indicate that a combination of these measures cannot be used to advantage. Any reference signs in the claims should not be construed as limited the scope.

## Claims

1. A computer-implemented method (700) of battery operation, the method (700) comprising:
determining (710), by one or more processors, a reference complex impedance of a reference cell over a range of one or more frequencies;
determining (720), by one or more processors, an in situ complex impedance, over the range of one or more frequencies, of each of one or more cells of a battery with measurement equipment, the battery and the measurement equipment in situ in an end use system, the measurement equipment comprising one more sense conductors operatively coupled to each one or more cell and one or more force conductors operatively coupled to the battery;
for each particular cell of the battery:
determining (730), by one or more processors, a model complex impedance (920) that, when in combination with the complex impedance of the particular cell (910), accounts at least in part for a difference between the in situ complex impedance of the particular cell (910) and the reference complex impedance;
adjusting (740), by one or more processors, the in situ complex impedance of the particular cell as a function of the model complex impedance (920); and
controlling (750), by one or more processors, operation of the battery based on the adjusted complex impedance of each of the particular cells.

2. The method (700) of claim 1, wherein the model complex impedance comprises at least one *R*∥*L* tank (921, 922, 923), the *R*∥*L* tank (921, 922, 923) comprising an inductance *L* and resistance *R* in parallel,.

3. The method (700) of claim 2, wherein each *R*∥*L* tank (921, 922, 923) in the model complex impedance (920) is in series.

4. The method (700) of claim 2 or claim 3, wherein each *R*∥*L* tank (921, 922, 923) represents at least one of:
coupling from electromagnetic fields created by the one or more force conductors on one or more sense conductors; mutual inductance between cells of the battery and measurement equipment; impedance introduced by contacts of the battery and measurement equipment; common mode current; skin effect; and eddy currents.

5. The method (700) of any preceding claim, wherein determining the reference complex impedance comprises determining the reference complex impedance in an environment that minimizes an effect of the measurement equipment on the determined impedance.

6. The method (700) of any preceding claim, wherein at least one of the following applies:
(a) the reference cell is a cell of the battery in situ with measurement equipment in the end use system;
(b) the reference cell is a cell of similar characteristics to each cell of the battery.

7. The method (700) of any preceding claim, wherein controlling operation of the battery comprises at least one of:
charging, under control of one or more processors, the battery based on the adjusted complex impedance of each of the particular cells; and
indicating, under control of one or more processors, replacement of one or more cells of the battery based on the adjusted complex impedance of each of the particular cells.

8. The method (700) of any preceding claim, wherein determining the model complex impedance comprises:
setting (1132), by one or more processors, a number of *R*∥*L* tanks *N_{RL}* for the model complex impedance;
determining (1134), by one or more processors, in an s-domain for each of a number of *R*∥*L* tanks *N_{RLInitial}* greater than *N_{RL},* gain as a function of time constant for the range of the one or more frequencies;
deriving, by one or more processors, *R* and *L* values for each of the *N_{RL}* {gain, time constant};
identify, by the one or more processor, pairs of most extrema gains; and
identifying the model complex impedance as the *N_{RL} R*∥*L* tanks having the derived *R* and *L* values.

9. The method (700) of any preceding claim, wherein determining the model complex impedance comprises:
setting (1132), by one or more processors, a number of *R*∥*L* tanks *N_{RL}* for the model complex impedance;
determining (1134), by one or more processors, in an s-domain for each of a number of *R*∥*L* tanks *N_{RLInitial}* greater than *N_{RL},* gain as a function of time constant for the range of the one or more frequencies; and
for each *N_{RL}*-combination of extrema of the gain as a function of time constant, including multiples of a same time constant, choosing (1136), by one or more processors, the R∥L tanks corresponding to the *N_{RL}*-combination that best accounts for the difference between the in situ complex impedance of the particular cell and the reference complex impedance.

10. The method (700) of any preceding claim, wherein determining the model complex impedance (920) comprises:
at each of a plurality of frequencies of interest, subtract real and imaginary parts of the reference cell complex impedance from the respective real and imaginary parts of the in situ complex impedance.

11. A system (1300) comprising:
a memory (1304) storing instructions therein; and
one or more processors (1302) communicatively coupled with the memory, the one or more processors (1302) being configured to execute the instructions to:
determine (710) a reference complex impedance of a reference cell over a range of one or more frequencies;
determine (720) an in situ complex impedance, over the range of one or more frequencies, of each of one or more cells of a battery with measurement equipment, the battery and the measurement equipment in situ in an end use system, the measurement equipment comprising one more sense conductors operatively coupled to each one or more cell and one or more force conductors operatively coupled to the battery; and
for each particular cell of the battery:
determine (730) a model complex impedance that, when in combination with the complex impedance of the particular cell, accounts at least in part for a difference between the in situ complex impedance of the particular cell and the reference complex impedance;
adjust (740) the in situ complex impedance of the particular cell as a function of the model complex impedance; and
control (750) operation of the battery based on the adjusted complex impedance of each of the particular cells.

12. The system (1300) of claim 11, wherein controlling operation of the battery comprises at least one of:
charging, under control of one or more processors, the battery based on the adjusted complex impedance of each of the particular cells; and
indicating, under control of one or more processors, replacement of one or more cells of the battery based on the adjusted complex impedance of each of the particular cells.

13. The system (1300) of claim 11 or claim 12, wherein determining the model complex impedance comprises:
setting (1132), by one or more processors, a number of *R*∥*L* tanks *N_{RL}* for the model complex impedance;
determining (1134), by one or more processors, in an s-domain for each of a number of *R*∥*L* tanks *N_{RLInitial}* greater than *N_{RL},* gain as a function of time constant for the range of the one or more frequencies;
deriving, by one or more processors, *R* and *L* values for each of the *N_{RL}* {gain, time constant};
identify, by the one or more processor, pairs of most extrema gains; and
identifying the model complex impedance as the *N_{RL} R*∥*L* tanks having the derived *R* and *L* values.

14. The system (1300) of any of claims 11 to 13, wherein determining the model complex impedance comprises:
setting (1132), by one or more processors, a number of *R*∥*L* tanks *N_{RL}* for the model complex impedance;
determining (1134), by one or more processors, in an s-domain for each of a number of *R*∥*L* tanks *N_{RLInitial}* greater than *N_{RL},* gain as a function of time constant for the range of the one or more frequencies; and
for each N_{RL}-combination of extrema of the gain as a function of time constant, including multiples of a same time constant, choosing (1136), by one or more processors, the R∥L tanks corresponding to the N_{RL}-combination that best accounts for the difference between the in situ complex impedance of the particular cell and the reference complex impedance,
and optionally wherein determining the model complex impedance further comprises,
at each of a plurality of frequencies of interest, subtracting real and imaginary parts of the reference cell complex impedance from the respective real and imaginary parts of the in situ complex impedance.

15. A computer program comprising computer executable instructions, the instructions when executed by one or more processors in a network being operative to perform the method (700) of any of claims 1 to 10.

## Patentansprüche

1. Computerimplementiertes Verfahren (700) für den Batteriebetrieb, das Verfahren (700) umfassend:
Bestimmen (710), durch einen oder mehrere Prozessoren, einer komplexen Referenzimpedanz einer Referenzzelle über einen Bereich einer oder mehrerer Frequenzen;
Bestimmen (720), durch einen oder mehrere Prozessoren, einer komplexen In-situ-Impedanz über den Bereich einer oder mehrerer Frequenzen für jede einer oder mehrerer Zellen einer Batterie mit einer Messeinrichtung, wobei die Batterie und die Messeinrichtung in situ in einem Endanwendungssystem angeordnet sind, wobei die Messeinrichtung einen oder mehrere Sensorleiter, die funktionsmäßig jeweils mit jeder von einer oder mehreren Zellen gekoppelt sind, sowie einen oder mehrere Kraftleiter umfasst, die funktionsmäßig mit der Batterie gekoppelt sind;
für jede einzelne Zelle der Batterie:
Bestimmen (730), durch einen oder mehrere Prozessoren, einer komplexen Modellimpedanz (920), die in Kombination mit der komplexen Impedanz der einzelnen Zelle (910) mindestens teilweise eine Differenz zwischen der komplexen In-situ-Impedanz der einzelnen Zelle (910) und der komplexen Referenzimpedanz erklärt;
Anpassen (740), durch einen oder mehrere Prozessoren, der komplexen In-situ-Impedanz der einzelnen Zelle als Funktion der komplexen Modellimpedanz (920); und
Steuern (750) des Betriebs der Batterie durch einen oder mehrere Prozessoren auf der Grundlage der angepassten komplexen Impedanz jeder der einzelnen Zellen.

2. Verfahren (700) nach Anspruch 1, wobei die komplexe Modellimpedanz mindestens ein *R*||*L*-Glied (921, 922, 923) umfasst, wobei das *R*||*L*-Glied (921, 922, 923) eine Induktivität *L* und einen Widerstand *R* in Parallelschaltung umfasst.

3. Verfahren (700) nach Anspruch 2, wobei jedes *R*||*L*-Glied (921, 922, 923) in der komplexen Modellimpedanz (920) in Reihe geschaltet ist.

4. Verfahren (700) nach Anspruch 2 oder Anspruch 3, wobei jedes *R*||*L*-Glied (921, 922, 923) mindestens eines von Folgendem darstellt:
Einkoppeln von elektromagnetischen Feldern, die von einem oder mehreren Kraftleitern erzeugt werden, in einen oder mehrere Sensorleiter; gegenseitige Induktivität zwischen den Zellen der Batterie und der Messeinrichtung; Impedanz, die durch Kontakte der Batterie und der Messeinrichtung verursacht wird; Gleichtaktstrom; Skin-Effekt; und Wirbelströme.

5. Verfahren (700) nach einem vorstehenden Anspruch, wobei das Bestimmen der komplexen Referenzimpedanz das Bestimmen der komplexen Referenzimpedanz in einer Umgebung umfasst, die einen Einfluss der Messeinrichtung auf die bestimmte Impedanz minimiert.

6. Verfahren (700) nach einem vorstehenden Anspruch, wobei mindestens eines von Folgendem zutrifft:
(a) die Referenzzelle ist eine Zelle der In-situ-Batterie, ausgestattet mit der Messeinrichtung, in dem Endanwendungssystem;
(b) die Referenzzelle ist eine Zelle mit ähnlichen Eigenschaften wie jede Zelle der Batterie.

7. Verfahren (700) nach einem vorstehenden Anspruch, wobei das Steuern des Betriebs der Batterie mindestens eines von Folgendem umfasst:
Laden, unter der Steuerung eines oder mehrerer Prozessoren, der Batterie auf der Grundlage der angepassten komplexen Impedanz jeder einzelnen Zelle; und
Anzeigen, unter der Steuerung eines oder mehrerer Prozessoren, des Austauschs von einer oder mehreren Zellen der Batterie auf der Grundlage der angepassten komplexen Impedanz jeder einzelnen Zelle.

8. Verfahren (700) nach einem vorstehenden Anspruch, wobei das Bestimmen der komplexen Modellimpedanz Folgendes umfasst:
Einstellen (1132), durch einen oder mehrere Prozessoren, einer Anzahl von *R*||*L*-Gliedern *N_{RL}* für die komplexe Modellimpedanz;
Bestimmen (1134), durch einen oder mehrere Prozessoren, in einem s-Bereich für jede von einer Anzahl von *R*||*L*-Gliedern *N_{RLInitial}*, die größer als *N_{RL} ist,* der Verstärkung als Funktion der Zeitkonstante für den Bereich der einen oder mehreren Frequenzen;
Ermitteln, durch einen oder mehrere Prozessoren, der *R*- und *L*-Werte für jedes von *N_{RL}* {Verstärkung, Zeitkonstante};
Identifizieren, durch einen oder mehrere Prozessoren, von Paaren mit den größten Extremwerten der Verstärkung; und
Identifizieren der komplexen Modellimpedanz als die *N_{RL} R*||*L*-Glieder, die die ermittelten *R*- und *L*-Werte aufweisen.

9. Verfahren (700) nach einem vorstehenden Anspruch, wobei das Bestimmen der komplexen Modellimpedanz Folgendes umfasst:
Einstellen (1132), durch einen oder mehrere Prozessoren, einer Anzahl von *R*||*L*-Gliedern *N_{RL}* für die komplexe Modellimpedanz;
Bestimmen (1134), durch einen oder mehrere Prozessoren, in einem s-Bereich für jeden einer Anzahl von *R*||*L*-Gliedern *N_{RLInitial}*, die größer als *N_{RL} ist,* der Verstärkung als Funktion der Zeitkonstante für den Bereich der einen oder mehreren Frequenzen; und
für jede *N_{RL}*-Kombination von Extremwerten der Verstärkung als Funktion der Zeitkonstante, einschließlich mehrerer derselben Zeitkonstante, Auswählen (1136), durch einen oder mehrere Prozessoren, der R||L-Glieder, die der *N_{RL}*-Kombination entsprechen, welche die Differenz zwischen der komplexen In-situ-Impedanz der einzelnen Zelle und der komplexen Referenzimpedanz am besten erklärt.

10. Verfahren (700) nach einem vorstehenden Anspruch, wobei das Bestimmen der komplexen Modellimpedanz (920) umfasst:
bei jeder von einer Vielzahl von interessierenden Frequenzen, Subtrahieren des Real- und des Imaginärteils der komplexen Impedanz der Referenzzelle von dem jeweiligen Real- und dem Imaginärteil der komplexen In-situ-Impedanz.

11. System (1300), umfassend:
einen Speicher (1304), in dem Anweisungen gespeichert sind, und
einen oder mehrere Prozessoren (1302), die kommunikativ mit dem Speicher gekoppelt sind, wobei der eine oder die mehreren Prozessoren (1302) ausgebildet sind, die Anweisungen für Folgendes auszuführen:
Bestimmen (710) einer komplexen Referenzimpedanz einer Referenzzelle über einen Bereich einer oder mehrerer Frequenzen;
Bestimmen (720) einer komplexen In-situ-Impedanz über den Bereich einer oder mehrerer Frequenzen für jede von einer oder mehreren Zellen einer Batterie mit einer Messeinrichtung, wobei die Batterie und die Messeinrichtung in situ in einem Endanwendungssystem angeordnet sind, wobei die Messeinrichtung einen oder mehrere Sensorleiter, die funktionsmäßig jeweils mit jeder von einer oder mehreren Zellen gekoppelt sind, sowie einen oder mehrere Kraftleiter umfasst, die funktionsmäßig mit der Batterie gekoppelt sind; und
für jede einzelne Zelle der Batterie:
Bestimmen (730) einer komplexen Modellimpedanz, die in Kombination mit der komplexen Impedanz der einzelnen Zelle mindestens teilweise eine Differenz zwischen der komplexen In-situ-Impedanz der einzelnen Zelle und der komplexen Referenzimpedanz erklärt;
Anpassen (740) der komplexen In-situ-Impedanz der einzelnen Zelle als Funktion der komplexen Modellimpedanz; und
Steuern (750) des Betriebs der Batterie auf der Grundlage der angepassten komplexen Impedanz jeder der einzelnen Zellen.

12. System (1300) nach Anspruch 11, wobei das Steuern des Betriebs der Batterie mindestens eines von Folgendem umfasst:
Laden, unter der Steuerung eines oder mehrerer Prozessoren, der Batterie auf der Grundlage der angepassten komplexen Impedanz jeder einzelnen Zelle; und
Anzeigen, unter der Steuerung eines oder mehrerer Prozessoren, des Austauschs von einer oder mehreren Zellen der Batterie auf der Grundlage der angepassten komplexen Impedanz jeder einzelnen Zelle.

13. System (1300) nach Anspruch 11 oder Anspruch 12, wobei das Bestimmen der komplexen Modellimpedanz Folgendes umfasst:
Einstellen (1132), durch einen oder mehrere Prozessoren, einer Anzahl von *R*||*L*-Gliedern *N_{RL}* für die komplexe Modellimpedanz;
Bestimmen (1134), durch einen oder mehrere Prozessoren, in einem s-Bereich für jede von einer Anzahl von *R*||*L*-Gliedern *N_{RLInitial}*, die größer als *N_{RL} ist,* der Verstärkung als Funktion der Zeitkonstante für den Bereich der einen oder mehreren Frequenzen;
Ermitteln, durch einen oder mehrere Prozessoren, der *R*- und *L*-Werte für jedes von *N_{RL}* {Verstärkung, Zeitkonstante};
Identifizieren, durch einen oder mehrere Prozessoren, von Paaren mit den größten Extremwerten der Verstärkung; und
Identifizieren der komplexen Modellimpedanz als die *N_{RL}-R*||*L*-Glieder, die die ermittelten *R*- und *L*-Werte aufweisen.

14. System (1300) nach einem der Ansprüche 11 bis 13, wobei das Bestimmen der komplexen Modellimpedanz Folgendes umfasst:
Einstellen (1132), durch einen oder mehrere Prozessoren, einer Anzahl von *R*||*L*-Gliedern *N_{RL}* für die komplexe Modellimpedanz;
Bestimmen (1134), durch einen oder mehrere Prozessoren, in einem s-Bereich für jede von einer Anzahl von *R*||*L*-Gliedern *N_{RLInitial}*, die größer als *N_{RL} ist,* der Verstärkung als Funktion der Zeitkonstante für den Bereich der einen oder mehreren Frequenzen; und
für jede *N_{RL}*-Kombination von Extremwerten der Verstärkung als Funktion der Zeitkonstante, einschließlich Vielfacher derselben Zeitkonstante, Auswählen (1136), durch einen oder mehrere Prozessoren, der R||L-Glieder, die der *N_{RL}*-Kombination entsprechen, welche die Differenz zwischen der komplexen In-situ-Impedanz der einzelnen Zelle und der komplexen Referenzimpedanz am besten erklärt,
und wobei das Bestimmen der komplexen Modellimpedanz wahlweise weiter umfasst,
bei jeder von einer Vielzahl von interessierenden Frequenzen, Subtrahieren des Real- und des Imaginärteils der komplexen Impedanz der Referenzzelle von dem jeweiligen Real- und Imaginärteil der komplexen In-situ-Impedanz.

15. Computerprogramm, umfassend computerausführbare Anweisungen, wobei die Anweisungen, wenn sie von einem oder mehreren Prozessoren in einem Netzwerk ausgeführt werden, dazu dienen, das Verfahren (700) nach einem der Ansprüche 1 bis 10 durchzuführen.

## Revendications

1. Procédé (700) mis en œuvre par ordinateur de fonctionnement de batterie, le procédé (700) comprenant :
la détermination (710), par un ou plusieurs processeurs, d'une impédance complexe de référence d'une cellule de référence sur une gamme d'une ou plusieurs fréquences ;
la détermination (720), par un ou plusieurs processeurs, d'une impédance complexe in situ, sur la gamme d'une ou plusieurs fréquences, de chacune d'une ou plusieurs cellules d'une batterie avec un équipement de mesure, la batterie et l'équipement de mesure étant in situ dans un système d'utilisation finale, l'équipement de mesure comprenant un ou plusieurs conducteurs de détection couplés fonctionnellement à chacune d'une ou plusieurs cellules et un ou plusieurs conducteurs de force couplés fonctionnellement à la batterie ;
pour chaque cellule particulière de la batterie :
la détermination (730), par un ou plusieurs processeurs, d'une impédance complexe modèle (920) qui, en combinaison avec l'impédance complexe de la cellule particulière (910), représente au moins en partie une différence entre l'impédance complexe in situ de la cellule particulière (910) et l'impédance complexe de référence ;
l'ajustement (740), par un ou plusieurs processeurs, de l'impédance complexe in situ de la cellule particulière en fonction de l'impédance complexe modèle (920) ; et
la commande (750), par un ou plusieurs processeurs, du fonctionnement de la batterie sur la base de l'impédance complexe ajustée de chacune des cellules particulières.

2. Procédé (700) selon la revendication 1, dans lequel l'impédance complexe modèle comprend au moins un réservoir *R*||*L* (921, 922, 923), le réservoir *R*||*L* (921, 922, 923) comprenant une inductance *L* et une résistance *R* en parallèle.

3. Procédé (700) selon la revendication 2, dans lequel chaque réservoir *R*||*L* (921, 922, 923) dans l'impédance complexe modèle (920) est en série.

4. Procédé (700) selon la revendication 2 ou la revendication 3, dans lequel chaque réservoir *R*||*L* (921, 922, 923) représente au moins l'un parmi :
un couplage de champs électromagnétiques créés par les un ou plusieurs conducteurs de force sur un ou plusieurs conducteurs de détection ; une inductance mutuelle entre des cellules de la batterie et un équipement de mesure ; une impédance introduite par des contacts de la batterie et de l'équipement de mesure ; un courant de mode commun ; un effet pelliculaire ; et des courants de Foucault.

5. Procédé (700) selon une quelconque revendication précédente, dans lequel la détermination de l'impédance complexe de référence comprend la détermination de l'impédance complexe de référence dans un environnement qui minimise un effet de l'équipement de mesure sur l'impédance déterminée.

6. Procédé (700) selon une quelconque revendication précédente, dans lequel au moins l'un de ce qui suit s'applique :
(a) la cellule de référence est une cellule de la batterie in situ avec un équipement de mesure dans le système d'utilisation finale ;
(b) la cellule de référence est une cellule aux caractéristiques similaires à chaque cellule de la batterie

7. Procédé (700) selon une quelconque revendication précédente, dans lequel la commande du fonctionnement de la batterie comprend au moins l'un parmi :
la charge, sous la commande d'un ou plusieurs processeurs, de la batterie sur la base de l'impédance complexe ajustée de chacune des cellules particulières ; et
l'indication, sous la commande d'un ou plusieurs processeurs, du remplacement d'une ou plusieurs cellules de la batterie sur la base de l'impédance complexe ajustée de chacune des cellules particulières.

8. Procédé (700) selon une quelconque revendication précédente, dans lequel la détermination de l'impédance complexe modèle comprend :
le réglage (1132), par un ou plusieurs processeurs, d'un nombre de réservoirs *R*||*L N_{RL}* pour l'impédance complexe modèle ;
la détermination (1134), par un ou plusieurs processeurs, dans un domaine s pour chacun d'un nombre de réservoirs *R*||*L N_{RLInitial}* supérieur à *N_{RL},* d'un gain en fonction de la constante de temps pour la gamme des une ou plusieurs fréquences ;
la déduction, par un ou plusieurs processeurs, de valeurs *R* et *L* pour chacun des *N_{RL}* {gain, constante de temps} ;
l'identification, par les un ou plusieurs processeurs, de paires de gains d'extrema les plus élevés ; et
l'identification de l'impédance complexe modèle en tant que réservoirs *R*||*L N_{RL}* présentant les valeurs *R* et *L* déduites.

9. Procédé (700) selon une quelconque revendication précédente, dans lequel la détermination de l'impédance complexe modèle comprend :
le réglage (1132), par un ou plusieurs processeurs, d'un nombre de réservoirs *R*||*L N_{RL}* pour l'impédance complexe modèle ;
la détermination (1134), par un ou plusieurs processeurs, dans un domaine s pour chacun d'un nombre de réservoirs *R*||*L N_{RLInitial}* supérieur à *N_{RL},* d'un gain en fonction de la constante de temps pour la gamme des une ou plusieurs fréquences ; et
pour chaque combinaison *N_{RL}* d'extrema du gain en fonction de la constante de temps, incluant des multiples d'une même constante de temps, le choix (1136), par un ou plusieurs processeurs, des réservoirs R||L correspondant à la combinaison *N_{RL}* qui représente le mieux la différence entre l'impédance complexe in situ de la cellule particulière et l'impédance complexe de référence.

10. Procédé (700) selon une quelconque revendication précédente, dans lequel la détermination de l'impédance complexe modèle (920) comprend :
à chacune d'une pluralité de fréquences d'intérêt, la soustraction des parties réelle et imaginaire de l'impédance complexe de cellule de référence des parties réelle et imaginaire respectives de l'impédance complexe in situ.

11. Système (1300) comprenant :
une mémoire (1304) sur laquelle sont stockées des instructions ; et
un ou plusieurs processeurs (1302) couplés en communication à la mémoire, les un ou plusieurs processeurs (1302) étant configurés pour mettre en œuvre les instructions pour :
déterminer (710) une impédance complexe de référence d'une cellule de référence sur une gamme d'une ou plusieurs fréquences ;
déterminer (720) une impédance complexe in situ, sur la gamme d'une ou plusieurs fréquences, de chacune d'une ou plusieurs cellules d'une batterie avec un équipement de mesure, la batterie et l'équipement de mesure étant in situ dans un système d'utilisation finale, l'équipement de mesure comprenant un ou plusieurs conducteurs de détection couplés fonctionnellement à chacune d'une ou plusieurs cellules et un ou plusieurs conducteurs de force couplés fonctionnellement à la batterie ; et
pour chaque cellule particulière de la batterie :
déterminer (730) une impédance complexe modèle qui, en combinaison avec l'impédance complexe de la cellule particulière, représente au moins en partie une différence entre l'impédance complexe in situ de la cellule particulière et l'impédance complexe de référence ;
ajuster (740) l'impédance complexe in situ de la cellule particulière en fonction de l'impédance complexe modèle ; et
commander (750) le fonctionnement de la batterie en fonction de l'impédance complexe ajustée de chacune des cellules particulières.

12. Système (1300) selon la revendication 11, dans lequel la commande du fonctionnement de la batterie comprend au moins l'un parmi :
la charge, sous la commande d'un ou plusieurs processeurs, de la batterie sur la base de l'impédance complexe ajustée de chacune des cellules particulières ; et
l'indication, sous la commande d'un ou plusieurs processeurs, du remplacement d'une ou plusieurs cellules de la batterie sur la base de l'impédance complexe ajustée de chacune des cellules particulières.

13. Système (1300) selon la revendication 11 ou la revendication 12, dans lequel la détermination de l'impédance complexe modèle comprend :
le réglage (1132), par un ou plusieurs processeurs, d'un nombre de réservoirs *R*||*L N_{RL}* pour l'impédance complexe modèle ;
la détermination (1134), par un ou plusieurs processeurs, dans un domaine s pour chacun d'un nombre de réservoirs *R*||*L N_{RLInitial}* supérieur à *N_{RL},* d'un gain en fonction de la constante de temps pour la gamme des une ou plusieurs fréquences ;
la déduction, par un ou plusieurs processeurs, de valeurs *R* et *L* pour chacun des *N_{RL}* {gain, constante de temps} ;
l'identification, par les un ou plusieurs processeurs, de paires de gains d'extrema les plus élevés ; et
l'identification de l'impédance complexe modèle en tant que réservoirs *R*||*L N_{RL}* présentant les valeurs *R* et *L* déduites.

14. Système (1300) selon l'une quelconque des revendications 11 à 13, dans lequel la détermination de l'impédance complexe modèle comprend :
le réglage (1132), par un ou plusieurs processeurs, d'un nombre de réservoirs *R*||*L N_{RL}* pour l'impédance complexe modèle ;
la détermination (1134), par un ou plusieurs processeurs, dans un domaine s pour chacun d'un nombre de réservoirs *R*||*L N_{RLInitial}* supérieur à *N_{RL},* du gain en fonction de la constante de temps pour la gamme d'une ou plusieurs fréquences ; et
pour chaque combinaison *N_{RL}* d'extrema du gain en fonction de la constante de temps, incluant des multiples d'une même constante de temps, le choix (1136), par un ou plusieurs processeurs, des réservoirs R||L correspondant à la combinaison *N_{RL}* qui représente le mieux la différence entre l'impédance complexe in situ de la cellule particulière et l'impédance complexe de référence,
et facultativement dans lequel la détermination de l'impédance complexe modèle comprend en outre,
à chacune d'une pluralité de fréquences d'intérêt, la soustraction des parties réelle et imaginaire de l'impédance complexe de cellule de référence des parties réelle et imaginaire respectives de l'impédance complexe in situ.

15. Programme informatique comprenant des instructions exécutables par ordinateur, les instructions, lorsqu'elles sont mises en œuvre par un ou plusieurs processeurs dans un réseau, étant conçues pour réaliser le procédé (700) selon l'une quelconque des revendications 1 à 10.
